# EUROPÄISCHE PATENTSCHRIFT

(11) **EP 3 410 606 B1**
(45) Veröffentlichungstag und Bekanntmachung des Hinweises auf die Patenterteilung: **03.03.2021**
(21) Anmeldenummer: 18175002.7
(22) Anmeldetag: 30.05.2018
(51) Int. Cl.: H04B 1/18, H04B 1/3877

(54) **SIGNALKOPPLUNGSVORRICHTUNG UND VERFAHREN ZUM BETRIEB EINER SIGNALKOPPLUNGSVORRICHTUNG**
SIGNAL COUPLING DEVICE AND METHOD FOR OPERATING SAME
DISPOSITIF DE COUPLAGE DU SIGNAL ET PROCÉDÉ DE FONCTIONNEMENT D'UN DISPOSITIF DE COUPLAGE DU SIGNAL

(30) Priorität: 31.05.2017 DE 102017209209
(43) Veröffentlichungstag der Anmeldung: 05.12.2018
(73) Patentinhaber: Laird Dabendorf GmbH, 15806 Zossen (DE)
(72) Erfinder: Nast, Helmut, 12557 Berlin (DE); Jacobi, Raimo, 10318 Berlin (DE); Sayed, Ahmed, 12355 Berlin (DE)
(74) Vertreter: Patentanwälte Bressel und Partner mbB

(56) Entgegenhaltungen:
- EP-A2- 0 410 698
- DE-A1- 4 303 110
- DE-A1-102014 213 933
- DE-A1-102014 225 022
- US-A1- 2006 058 072

## Beschreibung

Die Erfindung betrifft eine Signalkopplungsvorrichtung sowie ein Verfahren zum Betrieb einer Signalkopplungsvorrichtung.

Aus dem Stand der Technik sind Signalkopplungseinrichtungen bekannt, die zur signaltechnischen Verbindung eines Endgeräts, insbesondere eines Mobiltelefons, mit einer endgeräteexternen Antenne dienen. Derartige Signalkopplungseinrichtungen können insbesondere in Fahrzeugen vorgesehen werden, um ein Endgerät in einem Fahrzeuginnenraum mit einer Fahrzeugantenne signaltechnisch zu verbinden. Hierdurch kann einerseits eine hohe Signalqualität hergestellt, andererseits ein Energieverbrauch beim Betrieb des Endgeräts verringert werden. Derartige Signalkopplungseinrichtungen können hierbei derart ausgebildet sein, dass von der endgeräteexternen Antenne empfangene und zum Endgerät übertragene Signale und/oder vom Endgerät gesendete und an die endgeräteexterne Antenne übertragene Signale verarbeitet und/oder beeinflusst, insbesondere auch verstärkt, werden können.

Die WO 2016/008965 A1 beschreibt eine Signalkopplungseinrichtung, wobei die Signalkopplungseinrichtung mindestens einen Signalzweigabschnitt umfasst, der signaltechnisch mit einer endgeräteseitigen Schnittstelle der Signalkopplungseinrichtung verbunden oder verbindbar ist, wobei die Signalkopplungseinrichtung mindestens eine Steuer- und Auswerteeinrichtung umfasst, wobei mittels der Steuer- und Auswerteeinrichtung mindestens eine Signaleigenschaft eines auf dem mindestens einen Signalzweigabschnitt anliegenden Signals bestimmbar ist.

Die WO 2014/177556 A1 offenbart eine Schaltungsanordnung und ein Verfahren zum Kompensieren einer Signal-Dämpfung bei der Übertragung von Sendesignalen eines Mobilfunkgeräts.

Die DE 10 2014 225 022 A1 offenbart eine Vorrichtung und ein Verfahren zur Steuerung einer induktiven Ladevorrichtung in einem Fahrzeug, insbesondere eine Vorrichtung zur Steuerung einer induktiven Ladevorrichtung für mobile Endgeräte wie z.B. Mobilfunktelefone oder sogenannten Tablet-PCs.

Die DE 43 03 110 A1 offenbart Empfangssysteme für Tonrundfunk im Meterwellenbereich, die vorzugsweise für den mobilen Einsatz, z. B. in Kraftfahrzeugen, und für die Verwendung mit aktiven Antennen konzipiert sind.

Die DE 10 2014 213 933 A1 offenbart ein Verfahren zum Betrieb einer Signalkopplungseinrichtung sowie eine Signalkopplungseinrichtung.

Die EP 0 410 698 A2 offenbart ein berührungsfreies Telefon.

Die US 2006/058072 A offenbart eine Vorrichtung zur Verstärkung eines Signals zwischen einem Mobiltelefon und einer Zelle.

Es ist wünschenswert, eine Betriebssicherheit der Signalkopplungsvorrichtung zu erhöhen, insbesondere indem Bauteile der Signalkopplungsvorrichtung nicht mit unerwünscht hohen Signalleistungen beaufschlagt werden.

Somit stellt sich das technische Problem, eine Signalkopplungsvorrichtung sowie ein Verfahren zum Betrieb der Signalkopplungsvorrichtung zu schaffen, die eine Erhöhung der Betriebssicherheit ermöglichen. Die Lösung des technischen Problems ergibt sich durch die Gegenstände mit den Merkmalen der Ansprüche 1 und 13. Weitere vorteilhafte Ausgestaltungen der Erfindung ergeben sich aus den Unteransprüchen.

Vorgeschlagen wird eine Signalkopplungsvorrichtung zur Übertragung von Sendesignalen zwischen einem Endgerät und einer Antenne, insbesondere von dem Endgerät an die Antenne. Die Antenne bezeichnet hierbei eine endgeräteexterne Antenne. Sendesignale können hierbei in mindestens zwei, vorzugsweise jedoch in mehr als zwei Sendebändern, übertragen werden. Zusätzlich zur Übertragung von Sendesignalen kann die Signalkopplungsvorrichtung auch zur Übertragung von Empfangssignalen von der Antenne zum Endgerät dienen. Eine Sendeband bezeichnet hierbei ein Frequenzband, wobei ein in diesem Sendeband übertragenes Sendesignal eine Frequenz aus dem Frequenzband aufweist. Verschiedene Sendebänder können zur Übertragung Signalen, insbesondere Sendesignalen, gemäß verschiedener Standards, beispielsweise gemäß eines GSM-Standards, eines UMTS-Standards oder eines LTE-Standards dienen.

Beispielsweise können in den Sendebändern Signale gemäß des GSM850-Standards, des GSM900-Standards, des GSM1800-Standards, des GSM1900-Standards oder weiterer Standards übertragen werden. Weiter können Signale in einem Zeitduplex-Verfahren oder einem Frequenzduplex-Verfahren übertragen werden. Die Erfindung ist hierbei jedoch nicht auf die genannten Standards und Verfahren beschränkt und betrifft somit alle dem Fachmann bereits bekannten als auch zukünftige Standards und Verfahren.

Die Signalkopplungsvorrichtung umfasst mindestens eine endgeräteseitige Schnittstelle. Hierbei bezeichnet die endgeräteseitige Schnittstelle eine Schnittstelle, über die eine signaltechnische Verbindung zwischen der Signalkopplungsvorrichtung und dem Endgerät hergestellt werden kann. Die endgeräteseitige Schnittstelle kann hierbei eine bidirektionale Übertragung von Signalen ermöglichen. Beispielsweise kann die endgeräteseitige Schnittstelle einen sogenannten drahtlosen Koppler umfassen. Der drahtlose Koppler kann mindestens eine Spule zum Empfang von Sendesignalen des Endgeräts umfassen.

Die Signalkopplungsvorrichtung kann hierbei in einem Fahrzeug, insbesondere einem Kraftfahrzeug, angeordnet sein. Die endgeräteexterne Antenne kann hierbei insbesondere eine Fahrzeugantenne sein. Die Signalkopplungsvorrichtung kann weiter insbesondere Teil einer Mobilfunkverstärkungsvorrichtung sein oder eine Mobilfunkverstärkungsvorrichtung umfassen.

Im Sinne dieser Erfindung kann eine Verbindung eine signaltechnische Verbindung bezeichnen. Diese kann insbesondere eine galvanische und/oder induktive und/oder kapazitive Verbindung sein. Vorzugsweise ist eine Verbindung eine galvanische Verbindung. Bauteile der Signalkopplungsvorrichtung können vorzugsweise durch galvanische und induktive Verbindungen verbunden sein. Die Verbindung der Signalkopplungsvorrichtung mit dem Endgerät kann jedoch eine induktive Verbindung oder eine kapazitive Verbindung sein. Im Sinne dieser Erfindung umfasst der Begriff Verbindung auch eine Signalkopplung oder Kopplung, die nachfolgend noch näher erläutert wird.

Weiter umfasst die Signalkopplungsvorrichtung mindestens eine Dämpfungseinrichtung. Durch die Dämpfungseinrichtung kann ein Signal, insbesondere ein Signalpegel, gedämpft, also verringert, werden. Es ist jedoch auch möglich, dass mittels der Dämpfungseinrichtung ein Signalpegel erhöht, also verstärkt, wird. Die Dämpfungseinrichtung kann hierbei eine bandunspezifische Dämpfung oder Verstärkung durchführen, insbesondere mit dem gleichen Dämpfungs- oder Verstärkungsfaktor für die Signale aller Sendebänder. Somit kann die Dämpfungseinrichtung auch als breitbandige Dämpfungseinrichtung bezeichnet werden.

Weiter umfasst die Signalkopplungsvorrichtung einen Verbindungssignalzweig zur Verbindung der endgeräteseitigen Schnittstelle mit der Dämpfungseinrichtung. Insbesondere können die endgeräteseitige Schnittstelle und die Dämpfungseinrichtung galvanisch miteinander verbunden sein.

Erfindungsgemäß umfasst die Signalkopplungsvorrichtung mindestens eine erste Einrichtung zur Sendeaktivitätsdetektion. Diese kann auch als sogenannter Transmit-Detektor bezeichnet werden. Mittels der ersten Einrichtung zur Sendeaktivitätsdetektion kann insbesondere detektiert werden, ob ein vom Endgerät erzeugtes Sendesignal von der Signalkopplungsvorrichtung, insbesondere über die enggeräteseitige Schnittstelle, empfangen wird. Die erste Einrichtung zur Sendeaktivitätsdetektion ist signaltechnisch mit dem Verbindungssignalzweig gekoppelt. Insbesondere kann diese Kopplung über einen Leistungskoppler erfolgen. Alternativ ist es jedoch auch möglich, eine galvanische Verbindung zwischen dem Verbindungssignalzweig und der ersten Einrichtung zur Sendeaktivitätsdetektion bereitzustellen. Mit anderen Worten kann mittels der ersten Einrichtung zur Sendeaktivitätsdetektion eine Sendeaktivität des Endgeräts in Abhängigkeit des auf dem Verbindungssignalzweig anliegenden Signals detektierbar sein.

Weiter ist mittels der ersten Einrichtung zur Sendeaktivitätsdetektion ein Schutzsignal erzeugbar, wenn mindestens eine Signaleigenschaft, insbesondere ein Signalpegel, des auf dem Verbindungssignalzweig anliegenden Signals mehr als ein vorbestimmtes Maß von einer vorbestimmten schutzsignalspezifischen Signaleigenschaft abweicht. Diese kann z.B. durch Vorversuche oder Simulationen bestimmt werden. So ist das Schutzsignal erzeugbar, wenn eine Sendeleistung eines Sendesignals höher als eine vorbestimmte Schutzsignal-Leistung ist. Somit kann mittels der Einrichtung zur Sendeaktivitätsdetektion eine Sendeleistung eines detektierten Sendesignals bestimmbar sein. Die Signaleigenschaft des auf dem Verbindungssignalzweig anliegenden Signals kann in Abhängigkeit einer Signaleigenschaft des aus dem Verbindungssignalzweig ausgekoppelten Signals bestimmt werden.

Auch kann mittels der ersten Einrichtung zur Sendeaktivitätsdetektion ein Startsignal für eine sendebandspezifische Sendeaktivitätsdetektion erzeugbar sein. Diese wird nachfolgend noch näher erläutert. Insbesondere kann ein Startsignal zur sendebandspezifischen Sendeaktivitätsdetektion erzeugbar sein, wenn eine Signaleigenschaft mehr als ein vorbestimmtes Maß von einer vorbestimmten startsignalspezifischen Signaleigenschaft abweicht. Vorzugsweise ist das Startsignal erzeugbar, wenn die Sendeleistung des Sendesignals höher als eine vorbestimmte Startsignal-Leistung ist, wobei die Startsignal-Leistung geringer als die Schutzsignal-Leistung ist.

Weiter kann die Signalkopplungsvorrichtung eine Steuer- und Auswerteeinrichtung umfassen. Diese kann beispielsweise einen Mikrocontroller umfassen oder als solcher ausgebildet sein. Hierbei kann die erste Einrichtung zur Sendeaktivitätsdetektion mit der Steuer- und Auswerteeinrichtung verbunden sein, insbesondere zur Übertragung des Schutzsignals und zur Übertragung des erläuterten Startsignals.

Weiter kann mittels der Signalkopplungsvorrichtung eine Schutzfunktion durchgeführt werden, falls ein Schutzsignal erzeugt wurde. Die Schutzfunktion kann beispielsweise von der Steuer- und Auswerteeinrichtung durchgeführt oder gesteuert werden. Wie nachfolgend noch näher erläutert, kann insbesondere ein Dämpfungsfaktor der Dämpfungseinrichtung verändert werden. Diese kann beispielsweise durch die Steuer- und Auswerteeinrichtung gesteuert werden. Vorzugsweise kann jedoch auch das Schutzsignal unmittelbar von der ersten Einrichtung zur Sendeaktivitätsdetektion an die Dämpfungseinrichtung übertragen werden, wobei die Schutzfunktion, insbesondere die Veränderung des Dämpfungsfaktors, von der Dämpfungseinrichtung durchgeführt wird.

Alternative Schutzfunktionen können beispielsweise vorsehen, Signalzweige in der Signalkopplungsvorrichtung zu öffnen bzw. zu trennen, um die Übertragung von Sendesignalen mit unerwünschten Signaleigenschaften zu verhindern.

Hierdurch ergibt sich in vorteilhafter Weise eine erhöhte Betriebssicherheit der Signalkopplungsvorrichtung. Sendet ein Endgerät ein Sendesignal mit einer unerwünschten Signaleigenschaft, beispielsweise einer unerwünscht hohen Leistung, so besteht die Gefahr einer Beschädigung von Bauteilen der Signalkopplungsvorrichtung. Durch die erste Einrichtung zur Sendeaktivitätsdetektion kann ein derartiges Sendesignal aufgrund der Kopplung mit dem Verbindungssignalzweig zeitlich schnell, insbesondere unmittelbar nach dem Empfang durch die Signalkopplungsvorrichtung, detektiert werden, wodurch wiederum eine Schutzfunktion zeitlich schnell ausgelöst und durchgeführt werden kann. Insbesondere kann somit erreicht werden, dass Bauteile der Signalkopplungsvorrichtung nicht oder nur für sehr kurze Zeit einem Sendesignal mit unerwünschten Signaleigenschaften ausgesetzt sind.

In einer bevorzugten Ausführungsform ist die erste Einrichtung zur Sendeaktivitätsdetektion unmittelbar mit der Dämpfungseinrichtung verbunden. Insbesondere kann diese unmittelbare Verbindung der Übertragung des Schutzsignals von der ersten Einrichtung zur Sendeaktivitätsdetektion zur Dämpfungseinrichtung dienen. Eine unmittelbare Verbindung kann eine Verbindung zwischen der ersten Einrichtung zur Sendeaktivitätsdetektion und der Dämpfungseinrichtung bezeichnen, in der keine weiteren Signalverarbeitungseinrichtungen angeordnet sind.

Wie vorhergehend erläutert, kann alternativ das Schutzsignal auch von der ersten Einrichtung zur Sendeaktivitätsdetektion zur Steuer- und Auswerteeinrichtung übertragen werden, wobei die Steuer- und Auswerteeinrichtung in Abhängigkeit des Schutzsignals dann einen Betrieb der Dämpfungseinrichtung steuert, insbesondere einen Dämpfungsfaktor verändert, insbesondere erhöht.

Bei einer unmittelbaren Verbindung, insbesondere einer galvanischen Verbindung, kann die Dämpfungseinrichtung unmittelbar nach Empfang eines Schutzsignals einen Dämpfungsfaktor verändern, insbesondere erhöhen.

Hierdurch ergibt sich in vorteilhafter Weise eine zeitlich schnelle Durchführung der Schutzfunktion und somit ein verbesserter Schutz von Bauteilen der Signalkopplungsvorrichtung.

Weiter erfindungsgemäß ist der Dämpfungsfaktor der Dämpfungseinrichtung veränderbar, wenn ein Schutzsignal erzeugt wurde. Dies und entsprechende Vorteile wurden vorhergehend erläutert.

Die Veränderung eines Dämpfungsfaktors kann hierbei auch den Fall umfassen, dass die Dämpfungseinrichtung deaktiviert wird und somit keine Sendesignale überträgt.

In einer weiteren Ausführungsform ist die erste Einrichtung zur Sendeaktivitätsdetektion eine Einrichtung zur sendebandunspezifischen Sendeaktivitätsdetektion. Dies kann insbesondere bedeuten, dass die erste Einrichtung zur Sendeaktivitätsdetektion derart ausgebildet ist, dass mittels dieser Einrichtung ein sendebandunspezifisches Startsignal erzeugbar ist, wenn in mindestens einem Sendeband von mehreren Sendebändern ein Sendesignal übertragen wird. Hierbei kann das Startsignal unabhängig davon erzeugt werden, in welchem Sendeband das Sendesignal übertragen wird. Selbstverständlich kann auch mittels der Einrichtung zur sendebandunspezifischen Sendeaktivitätsdetektion das Schutzsignal erzeugbar sein, wenn in mindestens einem Sendeband ein Sendesignal übertragen wird, dessen Sendeleistung höher als die vorbestimmte Leistung ist. Hierbei kann auch das Schutzsignal unabhängig davon erzeugt werden, in welchem Sendeband das Sendesignal übertragen wird.

Hierdurch ergibt sich in vorteilhafter Weise, dass keine aufwendige Auftrennung eines über den Verbindungssignalzweig übertragenen Sendesignals in bandspezifische Anteile erfolgen muss. Hierdurch können in vorteilhafter Weise Bauraum und Kosten für die erste Einrichtung zur Sendeaktivitätsdetektion eingespart werden.

In einer weiteren Ausführungsform ist mittels der ersten Einrichtung zur Sendeaktivitätsdetektion ein gebündeltes Sendesignal erzeugbar, wobei das gebündelte Sendesignal die in mindestens zwei, vorzugsweise in allen, Sendebändern übertragbaren Anteile des aus dem Verbindungssignalzweig ausgekoppelten Signals bündelt. Weiter ist das Schutzsignal in Abhängigkeit mindestens einer Signaleigenschaft des gebündelten Sendesignals erzeugbar. Auch kann das Startsignal in Abhängigkeit mindestens einer Signaleigenschaft des gebündelten Sendesignals erzeugbar sein. Die Signaleigenschaft kann insbesondere ein Signalpegel sein.

Hierdurch ergibt sich in vorteilhafter Weise eine einfach zu implementierende Einrichtung zur Sendeaktivitätsdetektion zur Erzeugung eines Schutzsignals und gegebenenfalls eines Startsignals.

In einer weiteren Ausführungsform umfasst die erste Einrichtung zur Sendeaktivitätsdetektion mindestens ein Mittel zur Signaltrennung. Das Mittel zur Signaltrennung kann insbesondere eine frequenzunspezifische Signaltrennung durchführen, wobei die (herausgetrennten) Ausgangssignale des Mittels zur Signaltrennung jeweils das gleiche Spektrum wie das (zu trennende) Eingangssignal aufweisen. Es ist möglich, dass eine Anzahl von herausgetrennten Signalen der Anzahl an Sendebändern entspricht.

Das Mittel zur Signaltrennung kann insbesondere als Duplexer oder als Splitter ausgebildet sein. Weiter umfasst die erste Einrichtung zur Sendeaktivitätsdetektion mindestens ein Mittel zur Signalbündelung. Auch dieses kann als Splitter oder Duplexer ausgebildet sein. Das Mittel zur Signalbündelung kann auch als Combiner bezeichnet werden. Hierdurch ergibt sich in vorteilhafter Weise, dass sendebandspezifische Anteile des aus dem Verbindungssignalzweig ausgekoppelten Sendesignals aus diesem herausgetrennt und dann wieder gebündelt werden können. Hierdurch kann insbesondere ein Einfluss von Störgrößen auf die Schutz- oder Startsignalerzeugung reduziert werden.

Dies wiederum ermöglicht in vorteilhafter Weise eine zuverlässigere und robustere Erzeugung eines Schutzsignals oder Startsignals.

In einer weiteren Ausführungsform umfasst die erste Einrichtung zur Sendeaktivitätsdetektion mindestens ein Mittel zur Signalfilterung. Insbesondere kann dieses derart ausgebildet und/oder angeordnet sein, dass ein herausgetrennter Signalanteil gefiltert wird. Das Mittel zur Signalfilterung kann hierbei derart ausgebildet sein, dass ein gefiltertes Signal nur Frequenzen aus einem vorbestimmten Frequenzbereich aufweist, wobei der Frequenzbereich dem Frequenzbereich eines Sendebands entspricht. Insbesondere kann das Mittel zur Signalfilterung als Bandpassfilter ausgebildet sein. Insbesondere kann jedes der herausgetrennten Signale mit einem sendebandspezifischen Mittel zur Signalfilterung gefiltert werden, wobei das herausgetrennte, gefilterte Signal nur Frequenzen des sendebandspezifischen Frequenzbereichs aufweist. Somit kann das Mittel zur Signalfilterung auch als Selektionsmittel bezeichnet werden.

Der gefilterte, herausgetrennte Signalanteil kann dann wiederum mittels eines Mittels zur Signalbündelung mit anderen, vorzugsweise ebenfalls gefilterten, herausgetrennten Signalanteilen gebündelt werden. Hierdurch ergibt sich in vorteilhafter Weise eine weitere Reduktion des Einflusses von Störgrößen auf die Schutz- oder Startsignalerzeugung.

In einer weiteren Ausführungsform umfasst die erste Einrichtung zur Sendeaktivitätsdetektion mindestens eine Einrichtung zur Bestimmung eines Signalpegels des aus dem Verbindungssignalzweig ausgekoppelten Signals oder eines zu diesem Signalpegel proportionalen Signals. Insbesondere kann mittels dieser Einrichtung ein Signalpegel eines gebündelten Sendesignals bestimmt werden. Hierdurch ergibt sich in vorteilhafter Weise eine zuverlässige und einfach zu implementierende Bestimmung einer Signaleigenschaft, die dann wiederum eine zuverlässige Erzeugung eines Schutzsignals sowie eines Startsignals ermöglicht.

In einer weiteren Ausführungsform umfasst die erste Einrichtung zur Sendeaktivitätsdetektion mindestens eine Komparatoreinrichtung. Mittels der mindestens einen Komparatoreinrichtung kann insbesondere der mittels der Einrichtung zur Bestimmung des Signalpegels bestimmte Signalpegel mit einem vorbestimmten schutzsignalspezifischen Schwellwert verglichen werden. Weiter kann mittels der Komparatoreinrichtung ein Schutzsignal erzeugt werden, wenn der Signalpegel höher als der schutzsignalspezifische Schwellwert ist.

Weiter kann mittels der Komparatoreinrichtung oder einer weiteren Komparatoreinrichtung der Signalpegel mit einem vorbestimmten startsignalspezifischen Schwellwert verglichen werden, wobei ein Startsignal erzeugbar ist, wenn der Signalpegel höher als dieser startsignalspezifische Schwellwert ist. Der startsignalspezifische Schwellwert kann hierbei kleiner als der schutzsignalspezifische Schwellwert sein.

Insbesondere kann ein aus dem Verbindungssignalzweig ausgekoppeltes Signal in sendebandspezifische Anteile getrennt werden, beispielsweise mittels der vorhergehend erläuterten Mittel zur Signaltrennung. Diese Anteile wiederum können dann gefiltert werden, insbesondere mittels der Signalfilter. Die gefilterten Signalanteile können dann wiederum gebündelt werden, insbesondere mittels Mitteln zur Signalbündelung. Dann kann ein Signalpegel des gebündelten Signals bestimmt werden. Weiter kann dieser Signalpegel mit den erläuterten Schwellwerten verglichen werden.

In einer weiteren Ausführungsform umfasst die Signalkopplungsvorrichtung eine weitere Einrichtung zur Sendeaktivitätsdetektion. Diese weitere Einrichtung zur Sendeaktivitätsdetektion kann insbesondere eine sogenannte sendebandspezifische Einrichtung zur Sendeaktivitätsdetektion sein. Dies kann insbesondere bedeuten, dass mittels der weiteren Einrichtung zur Sendeaktivitätsdetektion ein bandspezifisches Sendeaktivitätssignal erzeugbar ist. Die weitere Einrichtung zur Sendeaktivitätsdetektion kann auch als Einrichtung zur Identifikation eines aktiven Sendebands bezeichnet werden, wobei in einem aktiven Sendeband ein Sendesignal übertragen wird. Ein sendebandspezifisches Sendeaktivitätssignal kann also insbesondere dann erzeugt werden, wenn genau in dem untersuchten Sendeband ein Sendesignal übertragen wird.

Es ist möglich, dass mittels der ersten Einrichtung ein Startsignal für die weitere Einrichtung zur Sendeaktivitätsdetektion erzeugbar ist. Somit kann eine sendebandspezifische Sendeaktivitätsdetektion mittels der weiteren Einrichtung zur Sendeaktivitätsdetektion gestartet oder initiiert wird, wenn mittels der ersten Einrichtung zur Sendeaktivitätsdetektion eine sendebandunspezifische Sendeaktivität detektiert wurde. Hierbei ist es vorstellbar, dass die Einrichtungen zur Sendeaktivitätsdetektion unmittelbar signaltechnisch verbunden sind. Auch kann die Verbindung, wie vorhergehend erläutert, über die Steuer- und Auswerteeinrichtung bereitgestellt werden. insbesondere kann von der ersten Einrichtung zur Sendeaktivitätsdetektion ein sendebandunspezifisches Startsignal an die Steuer- und Auswerteeinrichtung übertragen werden. Diese kann bei Empfang dieses Startsignals die weitere Einrichtung zur Sendeaktivitätsdetektion derart ansteuern, dass die sendebandspezifische Sendeaktivitätsdetektion, also die Identifikation eines aktiven Sendebands, gestartet bzw. initiiert wird.

Mittels der weiteren Einrichtung zur Sendeaktivitätsdetektion kann eine Sendeaktivitätsdetektion vorzugsweise in Abhängigkeit von einer Signaleigenschaft eines Signals durchgeführt werden, welches nicht an dem vorhergehend erläuterten Verbindungssignalzweig, sondern an einem von diesem Verbindungssignalzweig verschiedenen Signalzweig der Signalkopplungsvorrichtung anliegt.

In einer weiteren Ausführungsform umfasst die Signalkopplungsvorrichtung eine Signalverstärkungseinrichtung. Diese Signalverstärkungseinrichtung kann insbesondere eine sendebandspezifische Signalverstärkungseinrichtung sein. Dies kann bedeuten, dass die Signalkopplungsvorrichtung die in verschiedenen Sendebändern übertragenen Signale verschieden verstärken kann, beispielsweise indem sie pro Sendeband eine Signalverstärkungseinrichtung umfasst, wobei mittels dieser Verstärkungseinrichtungen jeweils das in einem Sendeband übertragende Sendesignal verstärkt werden kann. Verstärkungsfaktoren der Signalverstärkungseinrichtung(en) können hierbei einstellbar sein, insbesondere unabhängig voneinander. Die Signalverstärkungseinrichtung ist hierbei von der Dämpfungseinrichtung verschieden. Es ist hierbei möglich, dass die endgeräteseitige Schnittstelle über die Dämpfungseinrichtung mit der Verstärkereinrichtung verbunden ist.

Weiter ist mittels der weiteren Einrichtung zur Sendeaktivitätsdetektion ein aktives Sendeband in Abhängigkeit der durch die Signalverstärkungseinrichtung verstärkten Sendesignale detektierbar oder identifizierbar, wobei in dem aktiven Sendeband ein Sendesignal übertragen wird.

Hierbei kann die weitere Einrichtung zur Sendeaktivitätsdetektion signaltechnisch mit Signalausgangsanschlüssen der Signalverstärkungseinrichtung(en) gekoppelt sein. Diese Kopplung kann beispielsweise über mindestens einen oder mehrere Leistungskoppler erfolgen.

Insbesondere kann mittels der weiteren Einrichtung zur Sendeaktivitätsdetektion für jedes Sendeband mindestens eine Signaleigenschaft des in diesem Sendeband übertragenen Sendesignals bestimmbar sein, wobei das aktive Sendeband dann in Abhängigkeit der Signaleigenschaften detektierbar ist. Die Signaleigenschaft kann insbesondere wieder ein Signalpegel sein. Insbesondere kann ein aktives Sendeband detektiert werden, wenn die Signaleigenschaft einer vorbestimmten Signaleigenschaft entspricht, insbesondere wenn ein Signalpegel höher als ein vorbestimmter Schwellwert ist.

Alternativ oder kumulativ kann ein aktives Sendeband in Abhängigkeit eines Vergleichs der Signaleigenschaften der in den Sendebändern übertragenen Signale erfolgen. Beispielsweise kann als aktives Sendeband das Sendeband detektiert werden, dessen Signalpegel um mehr als ein vorbestimmtes Maß größer als der Signalpegel der Signale in den weiteren Sendebändern ist. Hierdurch ergibt sich in vorteilhafter Weise eine zuverlässige sendebandspezifische Sendeaktivitätsdetektion.

Es ist möglich, dass mittels der weiteren Einrichtung zur Sendeaktivitätsdetektion ein Ausgangssignal in Abhängigkeit der Signaleigenschaft, insbesondere des Signalpegels, also einer zur Signalleistung des Sendesignals (Sendeleistung) proportionalen Größe, erzeugt wird, wobei in Abhängigkeit des Ausgangssignals dann das aktive Sendeband detektierbar ist. Das Ausgangssignal kann insbesondere ein Spannungssignal sein.

Ein Zusammenhang zwischen der Signaleigenschaft und dem Ausgangssignal kann in Form einer Kennlinie gegeben sein. Über die Kennlinie kann einem Ausgangssignal eine Signaleigenschaft zugeordnet werden, insbesondere in eindeutiger Weise.

In einer weiteren Ausführungsform umfasst die weitere Einrichtung zur Sendeaktivitätsdetektion mindestens eine erste Schalteinrichtung und für jedes Sendeband einen bandspezifischen Eingangssignalzweig. Weiter ist durch die erste Schalteinrichtung ein ausgewählter bandspezifischer Eingangssignalzweig aus der Gruppe von Eingangssignalzeigen mit einem Ausgangssignalzweig der ersten Schalteinheit verbindbar. Weiter ist eine Signaleigenschaft des in einem Sendeband übertragenen Sendesignals als Signaleigenschaft des auf dem Ausgangssignalzweig der weiteren Einrichtung zur Sendeaktivitätsdetektion anliegenden Signals bestimmbar, wenn der entsprechende bandspezifische Eingangssignalzweig mit dem Ausgangssignalzweig verbunden ist. Hierbei können die bandspezifischen Eingangssignalzweige derart mit der endgeräteseitigen Schnittstelle, vorzugsweise mit den Ausgangsanschlüssen der bandspezifischen Verstärkereinrichtung(en), verbunden oder gekoppelt sein, dass über zumindest einen Abschnitt des bandspezifischen Eingangssignalzweigs, insbesondere über den mit der ersten Schalteinrichtung verbundenen Abschnitt, ein Signal übertragen wird, dessen Frequenzen in dem entsprechenden Sendeband liegen und welches proportional zu oder gleich dem Sendesignal, insbesondere dem bereits verstärkten Sendesignal, ist.

Hierdurch ergibt sich in vorteilhafter Weise, dass nicht für jedes Sendeband separate Einrichtungen zur Bestimmung einer Signaleigenschaft, insbesondere Einrichtungen zur Bestimmung eines Signalpegels, vorgesehen sein müssen. Hierdurch können ein Bauraum sowie Herstellungskosten der Signalkopplungsvorrichtung reduziert werden.

In einer weiteren Ausführungsform umfasst die weitere Einrichtung zur Sendeaktivitätsdetektion mindestens eine Einrichtung zur Signalbündelung und mindestens eine Einrichtung zur Signaltrennung des gebündelten Signals. Die Einrichtung zur Signalbündelung kann beispielsweise als sogenannte Daisy-Chain-Einrichtung ausgeführt sein oder eine solche umfassen. Mittels einer solchen Einrichtung zur Signalbündelung können die verstärkten Signale in den einzelnen Sendebändern oder davon abhängige Signale gebündelt werden. Weiter kann die Einrichtung zur Signaltrennung eine Filtereinrichtung, insbesondere eine Bandpassfiltereinrichtung, sein. Die durch die Einrichtung zur Signaltrennung herausgetrennten Signalanteile können z.B. über die bandspezifischen Eingangssignalzweige oder einen Abschnitt davon übertragen werden.

Die Filtereinrichtung kann hierbei derart ausgebildet sein, dass ein gefiltertes Signal nur Frequenzen aus einem vorbestimmten Frequenzbereich aufweist, wobei der Frequenzbereich dem Frequenzbereich eines Sendebands entspricht. Insbesondere kann in jedem Eingangssignalzweig ein sendebandspezifisches Mittel zur Signalfilterung angeordnet sein, welches das über den Eingangssignalzweig übertragene Signal derart filtert, dass das gefilterte Signal nur Frequenzen aus einem sendebandspezifischen Frequenzbereich aufweist.

Hierdurch ergibt sich in vorteilhafter Weise eine zuverlässige und genaue sendebandspezifische Sendeaktivitätsdetektion.

In einer weiteren Ausführungsform umfasst die weitere Einrichtung zur Sendeaktivitätsdetektion eine weitere Schalteinrichtung, wobei durch die weitere Schalteinrichtung ein Signalzweig zur Übertragung des gebündelten Signals mit jedem bandspezifischen Eingangssignalzweig aus der Gruppe von Eingangssignalzweigen der ersten Schalteinrichtung verbindbar ist. In den Eingangssignalzweigen der ersten Schalteinrichtung können die erläuterten Einrichtungen zur Signaltrennung, insbesondere die Filtereinrichtungen, angeordnet sein.

Die erste und weitere Schalteinrichtung der weiteren Einrichtung zur Sendeaktivitätsdetektion können hierbei synchron zueinander betrieben werden. Dies kann bedeuten, dass über die weitere Schalteinrichtung ein erster Eingangssignalzweig mit dem Signalzweig zur Übertragung des gebündelten Signals verbunden wird, wobei gleichzeitig mittels der ersten Schalteinrichtung dieser erste Eingangssignalzweig mit dem erläuterten Ausgangssignalzweig verbunden wird.

Der synchrone Betrieb kann hierbei mittels der Steuer- und Auswerteeinrichtung gesteuert werden.

Weiter kann die weitere Einrichtung zur Sendeaktivitätsdetektion eine Verstärkereinrichtung zur Verstärkung des gebündelten Signals umfassen. Diese Verstärkereinrichtung kann aktivierbar oder deaktivierbar sein. Insbesondere kann ein Betrieb der Verstärkereinrichtung durch die Steuer- und Auswerteeinrichtung gesteuert werden.

Hierdurch kann in vorteilhafter Weise eine Kennlinienverlängerung erreicht werden. Ist, wie vorhergehend erläutert, ein Zusammenhang zwischen der Signaleigenschaft und dem Ausgangssignal in Form einer Kennlinie gegeben, so kann es möglich sein, dass für bestimmte Wertebereiche der Signaleigenschaft, z.B. für geringe Werte des Signalpegels, kein zuverlässiges auswertbares Ausgangssignal erzeugbar ist. Durch die Verstärkung kann ein z.B. geringer Signalpegel verstärkt werden, was wiederum zur Erzeugung eines zuverlässig auswertbaren Ausgangssignals führt. Hierbei kann bei der Auswertung berücksichtigt werden, ob die Verstärkereinrichtung zur Verstärkung des gebündelten Signals aktiviert oder deaktiviert war. Bei einer aktivierten Verstärkereinrichtung kann z.B. das Ausgangssignal für oder bei der Auswertung um ein vorbestimmtes Maß verringert werden, insbesondere rechnerisch.

Weiter vorgeschlagen wird ein Verfahren zum Betrieb einer Signalkopplungsvorrichtung zur Übertragung von Sendesignalen zwischen einem Endgerät und einer Antenne gemäß einer der in dieser Offenbarung beschriebenen Ausführungsformen.

Erfindungsgemäß wird mittels der ersten Einrichtung zur Sendeaktivitätsdetektion ein Schutzsignal erzeugt, wenn mindestens eine Signaleigenschaft, insbesondere ein Signalpegel, des auf dem Verbindungssignalzweig anliegenden Signals mehr als ein vorbestimmtes Maß von einer vorbestimmten schutzsignalspezifischen Signaleigenschaft abweicht, z.B. wenn eine Sendeleistung eines Sendesignals, also des auf dem Verbindungssignalzweig anliegenden Signals, höher als eine vorbestimmte schutzsignalspezifische Leistung ist. Die vorbestimmte schutzsignalspezifische Leistung kann hierbei durch Versuche oder in Abhängigkeit von Bauteileigenschaften der Signalkopplungsvorrichtung bestimmt werden. Das Schutzsignal kann mit anderen Worten dann erzeugt werden, wenn ein Signal mit unerwünschten Signaleigenschaften in mindestens einem Sendeband übertragen wird.

Somit ist die Signalkopplungsvorrichtung derart konfiguriert, dass ein Verfahren gemäß einer der in dieser Offenbarung beschriebenen Ausführungsformen mittels der Signalkopplungsvorrichtung durchführbar ist.

Weiter kann mittels der ersten Einrichtung zur Sendeaktivitätsdetektion ein Startsignal erzeugt werden, wenn eine Signaleigenschaft mehr als ein vorbestimmtes Maß von einer vorbestimmten startsignalspezifischen Signaleigenschaft abweicht, z.B. wenn die Sendeleistung des auf dem Verbindungssignalzweig anliegenden Signals höher als eine vorbestimmte startsignalspezifische Leistung ist. Das Startsignal kann also dann erzeugbar sein, wenn in mindestens einem Sendeband ein Sendesignal übertragen wird. Hierdurch ergibt sich in vorteilhafter Weise eine zeitlich schnelle Detektion einer Sendeaktivität mit unerwünschten Signaleigenschaften. Dies wiederum ermöglicht in vorteilhafter Weise die schnelle Einleitung von Schutzfunktionen und somit eine erhöhte Betriebssicherheit der Signalkopplungsvorrichtung.

In einer weiteren Ausführungsform wird eine Schutzfunktion durchgeführt, wenn ein Schutzsignal erzeugt wurde. Die Schutzfunktion kann beispielsweise bewirken, dass Bauteile der Signalkopplungsvorrichtung nicht mit dem Sendesignal mit der unerwünschten Signaleigenschaften beaufschlagt werden. Beispielsweise kann eine Leistungsdämpfung des Sendesignals durchgeführt werden, wenn das Schutzsignal erzeugt wurde. Auch kann eine Trennung der Bauteile von dem Sendesignal durchgeführt werden. Hierdurch ergibt sich in vorteilhafter Weise eine erhöhte Betriebssicherheit für die Signalkopplungsvorrichtung.

Weiter erfindungsgemäß wird ein Dämpfungsfaktor der Dämpfungseinrichtung geändert, nämlich erhöht, wenn ein Schutzsignal erzeugt wurde. Das Schutzsignal kann hierbei unmittelbar von der ersten Einrichtung zur Sendeaktivitätsdetektion an die Dämpfungseinrichtung übertragen werden, wobei die Dämpfungseinrichtung nach Empfang des Schutzsignals den Dämpfungsfaktor verändert. Alternativ ist es auch möglich, das Schutzsignal an eine Steuer- und Auswerteeinrichtung zu übertragen, wobei die Steuer- und Auswerteeinrichtung die Dämpfungseinrichtung derart steuert, dass der Dämpfungsfaktor verändert wird. Hierdurch ergibt sich in vorteilhafter Weise eine zeitlich schnelle und einfache Implementierung der Schutzfunktion.

In einer weiteren Ausführungsform wird eine Sendeaktivitätsdetektion mittels einer weiteren Einrichtung zur Sendeaktivitätsdetektion gestartet, insbesondere eine sendebandspezifische Sendeaktivitätsdetektion, wenn bzw. nachdem eine Sendeaktivität, insbesondere eine sendebandunspezifische Sendeaktivität, durch die erste Einrichtung zur Sendeaktivitätsdetektion detektiert wurde. Mit anderen Worten kann ein aktives Sendeband detektiert oder identifiziert werden, wobei in dem aktiven Sendeband ein Sendesignal übertragen wird. Insbesondere kann ein sogenannter Scanvorgang gestartet werden, wobei z.B. die vorhergehend erläuterte erste und weitere Schalteinrichtung synchron angesteuert werden, um einen aktiven Eingangssignalzweig zu detektieren. Bei dem Scanvorgang kann insbesondere jeder Eingangssignalzweig der ersten Schalteinrichtung für eine vorbestimmte Mindestzeitdauer mit dem Ausgangssignalzweig der ersten Schalteinrichtung der weiteren Einrichtung zur Sendeaktivitätsdetektion verbunden werden, wobei dann in Abhängigkeit der Signaleigenschaften der auf dem Ausgangssignalzweig anliegenden Signale ein aktives Sendeband identifiziert wird.

Hierbei kann die Sendeaktivitätsdetektion mittels der weiteren Einrichtung zur Sendeaktivitätsdetektion in Abhängigkeit der durch eine Signalverstärkungseinrichtung verstärkten Sendesignale durchgeführt werden.

Weiter kann eine Verstärkung einer sendebandspezifischen oder -unspezifischen Verstärkereinrichtung im Sendebetrieb und/oder der Dämpfungsfaktor der Dämpfungseinrichtung in Abhängigkeit einer Signaleigenschaft, insbesondere eines Signalpegels, des durch die Signalverstärkungseinrichtung verstärkten Sendesignals und/oder in Abhängigkeit des identifizierten aktiven Sendebands eingestellt werden. Eine sendebandunspezifische Verstärkereinrichtung verstärkt hierbei die in den einzelnen Sendebändern übertragenen Sendesignale jeweils mit dem gleichen Verstärkungsfaktor während eine sendebandspezifische Verstärkereinrichtung die in den einzelnen Sendebändern übertragenen Sendesignale jeweils mit dem unabhängig voneinander einstellbaren Verstärkungsfaktoren verstärkt.

Weiter kann eine Nominal-Verstärkung einer sendebandspezifischen oder -unspezifischen Verstärkereinrichtung Verstärkereinrichtung und/oder eine Nominal-Dämpfung der Dämpfungseinrichtung, in Abhängigkeit einer Signaleigenschaft, insbesondere eines Signalpegels, des durch eine (sendebandspezifische) Signalverstärkungseinrichtung verstärkten Sendesignals bestimmt werden. Dies kann auch als Kalibrierung bezeichnet werden.

Weiter kann auch eine Kennlinienvermessung erfolgen. Diese kann auch als Kalibrierung bezeichnet werden. Hierbei kann, insbesondere in jedem Sendeband, ein Signal mit einer bekannten Sendeleistung übertragen werden. Weiter kann dann das Ausgangssignal, insbesondere als eine Ausgangsspannung, bestimmt werden, welches - wie vorhergehend erläutert - zur Detektion des aktiven Sendebands genutzt wird. Die Sendeleistung, das der bekannten Sendeleistung zugeordnete Ausgangssignal sowie die Zuordnung zu einer Sendeleistung kann dann gespeichert werden, z.B. in einer Speichereinrichtung. Diese kann Teil der Steuer- und Auswerteeinrichtung oder datentechnisch mit dieser verbunden sein. In Abhängigkeit dieser gespeicherten Information kann dann im Betrieb der Signalkoppplungsvorrichtung in Abhängigkeit eines Ausgangssignals eine Sendeleistung bestimmt werden.

Weiter kann auch eine Begrenzung der Sendeleistung auf eine maximal zulässige Sendeleistung erfolgen. Die maximal zulässige Sendeleistung kann eine sendebandspezifische Sendeleistung sein, insbesondere also für verschiedene Sendebänder verschieden sein. Insbesondere kann, z.B. mittels der Steuer- und Auswerteeinrichtung, eine Abweichung zwischen der maximal zulässigen Sendeleistung und der aktuellen Sendeleistung, die insbesondere in Abhängigkeit des erläuterten Ausgangssignals bestimmt wird, bestimmt werden. Die aktuelle Sendeleistung kann insbesondere in Abhängigkeit des von der weiteren Einrichtung zur Sendeaktivitätsdetektion erzeugten Ausgangssignals bestimmt werden, also insbesondere in Abhängigkeit des durch eine Signalverstärkungseinrichtung verstärkten Sendesignals. Die maximal zulässige Sendeleistung kann eine vorbestimmte Leistung sein.

Weiter kann der Dämpfungsfaktor der Dämpfungseinrichtung verändert werden, insbesondere erhöht werden, wenn die aktuelle Sendeleistung größer oder mehr als ein vorbestimmtes Maß größer als die maximal zulässige Sendeleistung ist. Hierbei kann der Dämpfungsfaktor derart verändert werden, dass die aktuelle Sendeleistung kleiner als die oder mehr als ein vorbestimmtes Maß kleiner als die oder gleich der maximal zulässige(n) Sendeleistung ist.

Es ist jedoch auch denkbar, dass ein vom Dämpfungsfaktor verschiedener Faktor, insbesondere ein Verstärkungsfaktor einer Verstärkereinrichtung der Signalkopplungsvorrichtung, derart verändert wird, dass die aktuelle Sendeleistung kleiner als die oder mehr als ein vorbestimmtes Maß kleiner als die oder gleich der maximal zulässige(n) Sendeleistung ist.

Weiter kann auch eine Begrenzung der Sendeleistung auf eine gewünschte Sendeleistung erfolgen. Die gewünschte Sendeleistung kann eine sendebandspezifische Sendeleistung sein, insbesondere also für verschiedene Sendebänder verschieden sein.

Eine Information über eine gewünschte Sendeleistung kann insbesondere von einer Basisstation an das Endgerät und/oder an die erfindungsgemäße Signalkopplungsvorrichtung, z.B. über das Endgerät, übertragen werden, insbesondere in Form eines so genannten Power Transmit Bit. Hierbei kann z.B. die Steuer- und Auswerteeinrichtung die gewünschte Sendeleistung in Abhängigkeit der übertragenen Information bestimmen.

Weiter kann dann, z.B. mittels der Steuer- und Auswerteeinrichtung, eine Abweichung zwischen der gewünschten Sendeleistung und der aktuellen Sendeleistung, die insbesondere in Abhängigkeit des erläuterten Ausgangssignals bestimmt wird, bestimmt werden.

Weiter kann der Dämpfungsfaktor der Dämpfungseinrichtung verändert werden, insbesondere erhöht oder erniedrigt werden, wenn die aktuelle Sendeleistung mehr als ein vorbestimmtes Maß von der gewünschten Sendeleistung abweicht. Hierbei kann der Dämpfungsfaktor derart verändert werden, dass die aktuelle Sendeleistung nicht oder nicht mehr als ein vorbestimmtes Maß von der gewünschten Sendeleistung abweicht. Es ist jedoch auch denkbar, dass ein vom Dämpfungsfaktor verschiedener Faktor, insbesondere ein Verstärkungsfaktor einer Verstärkereinrichtung der Signalkopplungsvorrichtung, derart verändert wird, dass die aktuelle Sendeleistung nicht oder nicht mehr als ein vorbestimmtes Maß von der gewünschten Sendeleistung abweicht.

Insbesondere kann die gewünschte Sendeleistung eine maximal gewünschte Sendeleistung sein. Dies kann von der maximal zulässigen Sendeleistung verschieden sein, insbesondere geringer. In diesem Fall kann der Dämpfungsfaktor derart verändert werden, dass die aktuelle Sendeleistung kleiner als die oder mehr als ein vorbestimmtes Maß kleiner als die oder gleich der gewünschte(n) Sendeleistung ist. Es ist jedoch auch denkbar, dass ein vom Dämpfungsfaktor verschiedener Faktor, insbesondere ein Verstärkungsfaktor einer Verstärkereinrichtung der Signalkopplungsvorrichtung, derart verändert wird, dass die aktuelle Sendeleistung kleiner als die oder mehr als ein vorbestimmtes Maß kleiner als die oder gleich der gewünschte(n) Sendeleistung ist.

Die Erfindung wird anhand von Ausführungsbeispielen näher erläutert. Die Figuren zeigen:
- Fig. 1: ein schematisches Schaltdiagramm einer erfindungsgemäßen Signalkopplungsvorrichtung in einer ersten Ausführungsform,
- Fig. 2: ein schematisches Schaltdiagramm einer erfindungsgemäßen Signalkopplungsvorrichtung in einer weiter Ausführungsform,
- Fig. 3: ein schematisches Schaltdiagramm einer ersten Einrichtung zur Sendeaktivitätsdetektion,
- Fig. 4: ein schematisches Schaltdiagramm einer ersten Einrichtung zur Sendeaktivitätsdetektion in einer weiteren Ausführungsform,
- Fig. 5: ein schematisches Schaltdiagramm einer weiteren Einrichtung zur Sendeaktivitätsdetektion in einer weiteren Ausführungsform,
- Fig. 6: ein schematisches Schaltdiagramm einer Signalbündelung,
- Fig. 7: ein schematisches Schaltdiagramm einer aktivier- und deaktivierbaren Verstärkereinrichtung,
- Fig. 8: ein schematisches Schaltdiagramm einer sendebandspezifischen Verstärkereinrichtung und
- Fig. 9: ein schematisches Flussdiagramm eines erfindungsgemäßen Verfahrens.

Nachfolgend bezeichnen gleiche Bezugszeichen Elemente mit gleichen oder ähnlichen technischen Merkmalen.

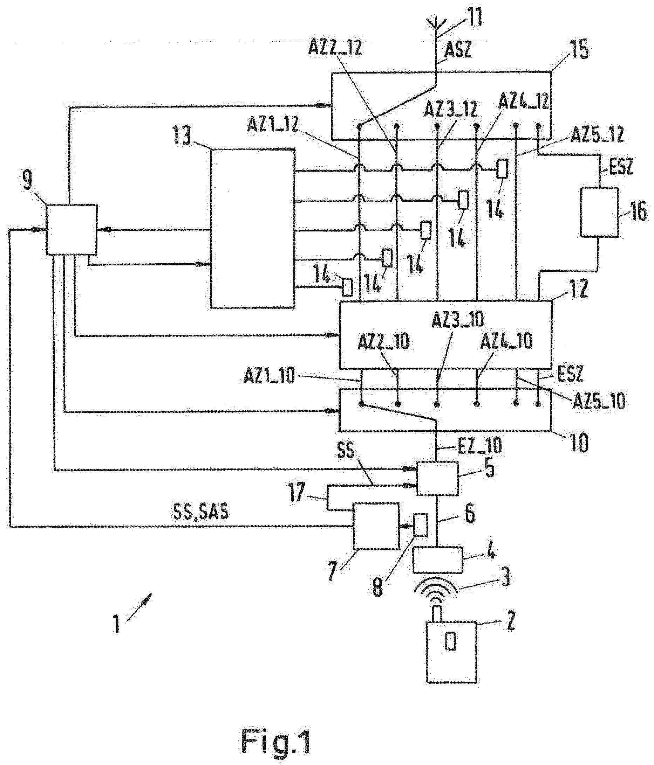

In Fig. 1 ist ein schematisches Schaltdiagramm einer erfindungsgemäßen Signalkopplungsvorrichtung 1 dargestellt. Dargestellt ist ein Endgerät 2, welches beispielsweise ein Mobilfunktelefon sein kann. Schematisch dargestellt ist ein Sendesignal 3 des Mobilfunktelefons.

Die Signalkopplungsvorrichtung 1 umfasst eine endgeräteseitige Schnittstelle 4, wobei mittels der endgeräteseitigen Schnittstelle 4 das Sendesignal 3 des Endgeräts 2 empfangen werden kann. Die endgeräteseitige Schnittstelle 4 kann hierbei einen drahtlosen Koppler umfassen oder ausbilden. Weiter umfasst die Signalkopplungsvorrichtung 1 eine Dämpfungseinrichtung 5. Diese kann vorzugsweise eine Dämpfungseinrichtung 5 mit einstellbarem Dämpfungsfaktor sein. Weiter umfasst die Signalkopplungsvorrichtung 1 einen Verbindungssignalzweig 6, der die endgeräteseitige Schnittstelle mit der Dämpfungseinrichtung 5 verbindet, insbesondere galvanisch.

Weiter umfasst die Signalkopplungsvorrichtung 1 eine erste Einrichtung 7 zur Sendeaktivitätsdetektion. Weiter umfasst die Signalkopplungsvorrichtung 1 eine Signalkopplungseinrichtung 8, wobei die erste Einrichtung 7 zur Sendeaktivitätsdetektion über die Signalkopplungseinrichtung 8, die z.B. als Leistungskoppler ausgebildet sein kann, mit dem Verbindungssignalzweig 6 signaltechnisch gekoppelt ist. Die erste Einrichtung 7 zur Sendeaktivitätsdetektion ist signaltechnisch unmittelbar über einen weiteren Verbindungssignalzweig 17 galvanisch mit der Dämpfereinrichtung 5 verbunden. Weiter ist die erste Einrichtung 7 signaltechnisch mit einer Steuer- und Auswerteeinrichtung 9 verbunden. Diese kann als Mikrocontroller ausgebildet sein oder einen solchen umfassen.

Die Signalkopplungsvorrichtung 1 umfasst weiter eine Schalteinrichtung 10, wobei mittels der Schalteinrichtung 10 ein einzelner Eingangssignalzweig EZ_10 der Schalteinrichtung 10 mit fünf Ausgangssignalzweigen AZ1_10, ..., AZ5_10 der Schalteinrichtung 10 oder mit einem Empfangssignalzweig ESZ verbindbar ist. In dem in Fig. 1 dargestellten Ausführungsbeispiel kann die Übertragung eines Sendesignals 3 von dem Endgerät 2 zu einer endgeräteexternen Antenne 11 in fünf Frequenzbändern, die auch als Sendebänder bezeichnet werden können, erfolgen, wobei ein Ausgangssignalzweig AZ1_10, ..., AZ5_10 der Schalteinrichtung 10 ein sendebandspezifischer Signalzweig sein kann. Dies ist jedoch nur exemplarisch. Selbstverständlich kann die Übertragung auch in mehr als fünf oder in weniger als fünf Sendebändern erfolgen.

Weiter umfasst die Signalkopplungsvorrichtung 1 eine Verstärkereinrichtung 12. Diese kann die auf den Ausgangssignalzweigen AZ1_10, ..., AZ5_10 der Schalteinrichtung 10 anliegenden Signale verstärken. Hierbei kann die Verstärkereinrichtung 12 diese Signale signalzweigspezifisch oder signalzweigunspezifisch verstärken. Dies kann bedeuten, dass jedes der in den fünf Ausgangssignalzweigen AZ1_10, ..., AZ5_10 der Schalteinrichtung 10 übertragenen Signale mit verschiedenen Verstärkungsfaktoren oder mit gleichen Verstärkungsfaktoren verstärkt werden können.

Weiter umfasst die Signalkopplungsvorrichtung eine weitere Einrichtung 13 zur Sendeaktivitätsdetektion. Diese ist über Leistungskoppler 14 mit den Ausgangssignalzweigen AZ1_12, ..., AZ5_12 der Verstärkereinrichtung 12 signaltechnisch gekoppelt. Mittels der weiteren Einrichtung 13 zur Sendeaktivitätsdetektion kann eine sendebandspezifische Sendeaktivitätsdetektion durchgeführt werden. Dies kann bedeuten, dass ein aktives Sendeband identifiziert wird, also ein Sendeband aus der Menge von möglichen Sendebändern, wobei in diesem aktiven Sendeband das Sendesignal 3 übertragen wird.

Weiter dargestellt ist eine weitere Schalteinrichtung 15 der Signalkopplungsvorrichtung 1, wobei mittels der weiteren Schalteinrichtung 15 jeder der Ausgangssignalzweige AZ1_12, ..., AZ5_12 der ersten Schalteinrichtung 12 oder der Empfangssignalzweig ESZ mit einem Antennensignalzweig ASZ verbindbar ist. Mittels der Steuer- und Auswerteeinrichtung 9 kann ein Betrieb der Schalteinrichtungen 12, 15, ein Betrieb der weiteren Einrichtung 7 zur Sendeaktivitätsdetektion und ein Betrieb der Dämpfungseinrichtung 5 sowie ein Betrieb der Verstärkereinrichtung 12 steuerbar sein. Beispielsweise kann ein Dämpfungsfaktor der Dämpfungseinrichtung 5 durch die Steuer- und Auswerteeinrichtung 9 einstellbar sein. Weiter kann ein oder mehrere Verstärkungsfaktor(en) der Verstärkereinrichtung 12 durch die Steuer- und Auswerteeinrichtung 9 einstellbar sein. Dies ist jedoch nicht zwingend erforderlich.

Schematisch dargestellt ist auch der Empfangssignalzweig ESZ, wobei mittels der ersten und weiteren Schalteinrichtung 10, 15 der Antennensignalzweig ASZ auch mit dem Empfangssignalzweig ESZ und der Eingangssignalzweig EZ_10 der ersten Schalteinrichtung 10 mit dem Empfangssignalzweig ESZ verbindbar ist. Dies kann insbesondere auch in einem so genannten Transparent-Modus erfolgen, in dem keine Anrufdaten übertragen werden. Weiter dargestellt ist eine Verstärkereinrichtung 16, welche in diesem Empfangssignalzweig ESZ angeordnet ist und ein Empfangssignal, welches von der Antenne 11 zum Endgerät 2 übertragen werden soll, verstärken kann. Weiter ist auch die Verstärkereinrichtung 12 im Empfangssignalzweig ESZ angeordnet. Hierbei kann das Empfangssignal auch durch die Verstärkereinrichtung 12 verstärkt werden.

Nicht dargestellt ist, dass die Auswerte- und Steuereinrichtung 9 auch den Betrieb dieser Verstärkereinrichtung 16 im Empfangssignalzweig ESZ steuern kann.

In Fig. 1 ist dargestellt, dass die erste Einrichtung 7 zur Sendeaktivitätsdetektion signaltechnisch unmittelbar, insbesondere galvanisch, mit der Dämpfungseinrichtung 5 verbunden sein kann. Über diese unmittelbare Signalverbindung, die durch einen weiteren Verbindungssignalzweig 17 bereitgestellt wird, kann ein Schutzsignal SS, welches von der ersten Einrichtung 7 zur Sendeaktivitätsdetektion erzeugt werden kann, an die Dämpfungseinrichtung 5 übertragen werden.

Hierbei kann das Schutzsignal SS von der ersten Einrichtung 7 zur Sendeaktivitätsdetektion erzeugt werden, wenn eine Signaleigenschaft des aus dem Verbindungssignalzweig 6 ausgekoppelten Signals mehr als ein vorbestimmtes Maß von einer vorbestimmten Eigenschaft abweicht, insbesondere wenn eine Sendeleistung des aus dem Verbindungssignalzweig 6 ausgekoppelten Signals höher als eine vorbestimmte schutzsignalspezifische Leistung ist. Diese kann durch Kalibrieren oder Simulation ermittelt werden.

Insbesondere kann mittels der ersten Einrichtung 7 ein Signalpegel des aus dem Verbindungssignalzweig 6 ausgekoppelten Signals bestimmt werden und das Schutzsignal SS erzeugt werden, wenn der Signalpegel dieses Signals höher als ein vorbestimmter schutzsignalspezifischer Pegel ist. Empfängt die Dämpfungseinrichtung 5 das Schutzsignal SS, welches von der ersten Einrichtung 7 zur Sendeaktivitätsdetektion erzeugt wurde und über den weiteren Verbindungssignalzweig 17 übertragen wurde, so kann die Dämpfungseinrichtung 5 den Dämpfungsfaktor verändern, insbesondere erhöhen.

Alternativ oder kumulativ ist es möglich, dass das erzeugte Schutzsignal SS von der ersten Einrichtung 7 zur Sendeaktivitätsdetektion an die Steuer- und Auswerteeinrichtung 9 übertragen wird. Hierbei kann die Steuer- und Auswerteeinrichtung 9 die Durchführung einer Schutzfunktion steuern, wenn das Schutzsignal SS empfangen wurde. Beispielsweise kann die Steuer- und Auswerteeinrichtung 9 einen Dämpfungsfaktor der Dämpfungseinrichtung 5 verändern, insbesondere erhöhen.

Hierdurch kann in vorteilhafter Weise ein Sendesignal 3, welches mit einer unerwünschten Signaleigenschaft von dem Endgerät 2 übertragen wird, gedämpft werden. Dies ermöglicht in vorteilhafterweise eine erhöhte Betriebssicherheit für die Signalkopplungsvorrichtung 1, da die Bauteile, beispielsweise die Schalteinrichtungen 10, 15 sowie die Verstärkereinrichtung 12, nicht mit Signalen beaufschlagt werden, die eine zu hohe Leistung aufweisen.

Weiter kann mittels der ersten Einrichtung 7 zur Sendeaktivitätsdetektion ein Startsignal SAS erzeugt werden, wenn die Signaleigenschaft des angekoppelten Signals um mehr als ein vorbestimmtes Maß von einer vorbestimmten startsignalspezifischen Eigenschaft abweicht, insbesondere wenn eine Sendeleistung des aus dem Verbindungssignalzweig 6 ausgekoppelten Signals höher als eine vorbestimmte startsignalspezifische Leistung ist. Diese kann durch Kalibrieren oder Simulation ermittelt werden. Dieses Startsignal SAS kann an die Steuer- und Auswerteeinrichtung 9 übertragen werden. Empfängt die Steuer- und Auswerteeinrichtung 9 ein solches Startsignal SAS, so kann eine Sendeaktivitätsdetektion, insbesondere die Detektion oder Identifikation eines aktiven Sendebands, mittels der weiteren Einrichtung 13 zur Sendeaktivitätsdetektion gestartet werden. Hierzu kann die Steuer- und Auswerteeinrichtung 9 diese weitere Einrichtung 13 zur Sendeaktivitätsdetektion ansteuern.

In Fig. 1 wird die Sendeaktivitätsdetektion, insbesondere also die Detektion eines aktiven Sendebands, durch die weitere Einrichtung 13 zur Sendeaktivitätsdetektion in Abhängigkeit von verstärkten Signalen, die auf den Ausgangssignalzweigen AZ1_12, ..., AZ5_12 der Verstärkereinrichtung 12 anliegen, durchgeführt. Hierdurch ergibt sich in vorteilhafter Weise, dass neben der Detektion bzw. Identifikation eines aktiven Sendebands auch eine Sendeleistung der verstärkten und auf den Ausgangssignalzweigen AZ1_12, ..., AZ5_12 anliegenden Signalen bestimmt werden kann. Diese Sendeleistung entspricht im Wesentlichen oder mit nur geringen Abweichungen der über die Antenne 11 übertragenen Sendeleistung, da Signalverluste zwischen dem Bestimmungsort der Signalleistung und der Antenne 11 minimal sind. Weicht eine derart bestimmte Signalleistung um mehr als ein vorbestimmtes Maß von einer gewünschten Signalleistung ab, so kann, insbesondere mittels der Steuer- und Auswerteeinrichtung 9, die Verstärkereinrichtung 12 derart gesteuert werden, dass eine gewünschte Signalleistung erreicht wird.

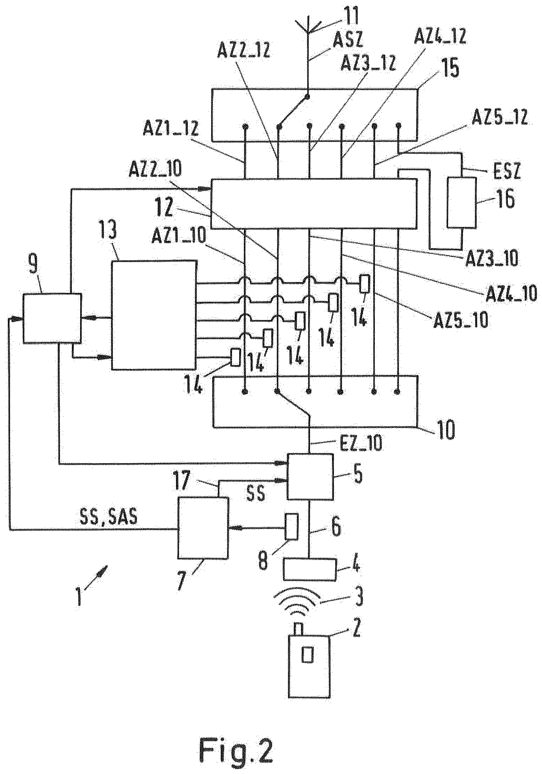

Fig. 2 zeigt ein schematisches Schaltdiagramm einer Signalkopplungsvorrichtung 1 in einer weiteren Ausführungsform. Die Signalkopplungsvorrichtung in der in Fig. 2 dargestellten Ausführungsform ist hierbei im Wesentlichen wie die in Fig. 1 dargestellte Signalkopplungsvorrichtung 1 ausgebildet. Daher wird auf die entsprechenden Erläuterungen zu Fig. 1 verwiesen. Im Unterschied zu der in Fig. 1 dargestellten Ausführungsform der Signalkopplungsvorrichtung 1 wird die Sendeaktivitätsdetektion, insbesondere die sendebandspezifische Sendeaktivitätsdetektion, mittels der weiteren Einrichtung 13 zur Sendeaktivitätsdetektion in Abhängigkeit von unverstärkten Signalen durchgeführt, wobei diese Signale auf den Ausgangssignalzweigen AZ1_10, ..., AZ5_10 der ersten Schalteinrichtung 10 anliegen.

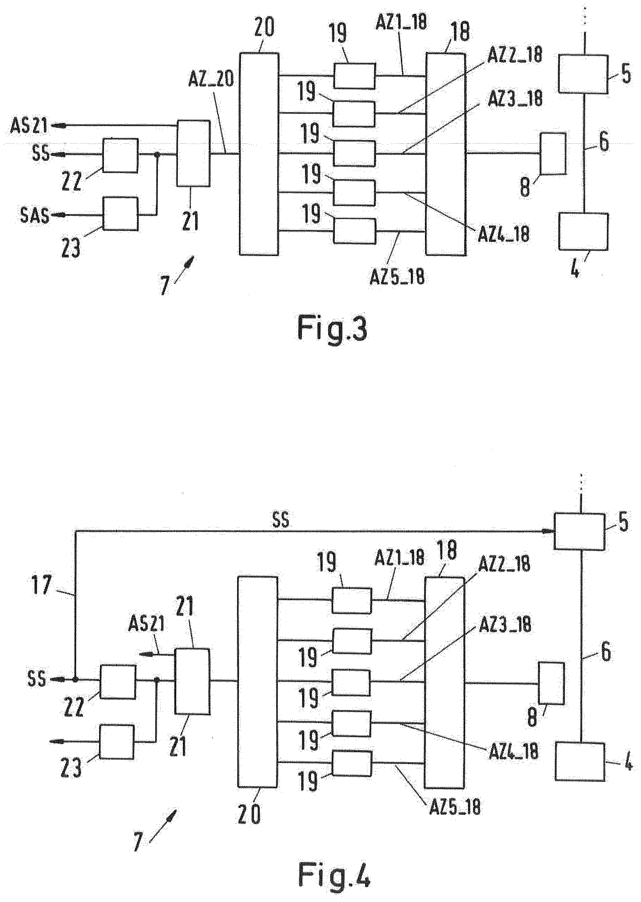

In Fig. 3 ist ein schematisches Schaltdiagramm einer ersten Einrichtung 7 zur Sendeaktivitätsdetektion dargestellt. Dargestellt ist weiter die endgeräteseitige Schnittstelle 4, der Verbindungssignalzweig 6 und die Dämpfungseinrichtung 5. Ebenfalls dargestellt ist die z.B. als Leistungskoppler ausgebildete Signalkopplungseinrichtung 8.

Die erste Einrichtung 7 zur Sendeaktivitätsdetektion kann hierbei eine Einrichtung 18 zur Signaltrennung aufweisen. Diese kann beispielsweise eine Splittereinrichtung und/oder einen Duplexer umfassen.

Mittels der Einrichtung zur Signaltrennung 18 kann das aus dem Verbindungssignalzweig 6 ausgekoppelte Signal in sendebandspezifische Signalanteile aufgetrennt werden. Insbesondere kann über einen ersten Ausgangssignalzweig AZ1_18 der Einrichtung zur Signaltrennung 18 ein Signalanteil übertragen werden, dessen Frequenzen im ersten Sendeband liegen. Entsprechend können über weitere Ausgangssignalzweige AZ2_18, AZ3_18, AZ4_18, AZ5_18 Signalanteile übertragen werden, deren Frequenzen in den weiteren Sendebändern liegen.

Weiter kann die erste Einrichtung 7 zur Sendeaktivitätsdetektion Filtereinrichtungen 19 umfassen. Diese können insbesondere als Bandpassfilter ausgebildet sein. Hierbei können die Filtereinrichtungen 19 die über die Ausgangssignalzweige AZ1_18, ..., AZ5_18 der Einrichtung zur Signaltrennung 18 übertragenen Signale filtern. Die Bandpassfiltereinrichtungen können hierbei Grenzfrequenzen aufweisen, die an die jeweiligen Sendebänder angepasst sind. So können beispielsweise mittels des Bandpassfilters 19 im ersten Ausgangssignalzweig AZ1_18 Signalanteile aus dem übertragenen Signal gefiltert werden, deren Frequenzen im ersten Sendeband liegen.

Hierdurch können Störeinflüsse auf das ausgekoppelte Signal verringert werden, die zu einer fehlerhaften Erzeugung eines Schutzsignals SS oder eines Startsignals SAS führen könnten.

Weiter umfasst die erste Einrichtung 7 zur Sendeaktivitätsdetektion eine Einrichtung 20 zur Signalbündelung. Mittels der Einrichtung 20 zur Signalbündelung können die auf den Ausgangssignalzweigen AZ1_18, ..., AZ5_18 anliegenden und mittels der Filtereinrichtung 19 gefilterten Signalanteile gebündelt werden. Das gebündelte Signal kann dann über einen Ausgangssignalzweig AZ_20 der Einrichtung 20 zur Signalbündelung an eine Einrichtung 21 zur Bestimmung eines Signalpegels übertragen werden. Die erste Einrichtung 7 zur Sendeaktivitätsdetektion umfasst hierbei diese Einrichtung 21 zur Bestimmung eines Signalpegels. Diese Einrichtung 21 zur Bestimmung eines Signalpegels kann beispielsweise als Gleichrichter ausgebildet sein oder einen solchen umfassen.

Weiter umfasst die erste Einrichtung 7 zur Sendeaktivitätsdetektion eine erste Komparatoreinrichtung 22. Mittels der ersten Komparatoreinrichtung 22 ist ein Ausgangssignal der Einrichtung 21 zur Bestimmung eines Signalpegels, welches einen Signalpegel repräsentiert bzw. proportional zu dem Signalpegel ist, mit einem vorbestimmten schutzsignalspezifischen Signalpegel vergleichbar. Hierbei wird ein Schutzsignal SS erzeugt, falls der Signalpegel größer als vorbestimmte schutzsignalspezifische Signalpegel ist. Mittels der weiteren Komparatoreinrichtung 23 kann das Ausgangssignal der Einrichtung 21 zur Bestimmung eines Signalpegels mit einem vorbestimmten startsignalspezifischen Signalpegel verglichen werden, wobei ein Startsignal SAS erzeugt wird, wenn das Ausgangssignal größer als dieser startsignalspezifische Signalpegel ist. Der schutzsignalspezifische Signalpegel kann hierbei größer als der startsignalspezifische Signalpegel sein. Es ist weiter dargestellt, dass auch das von der Einrichtung 21 zur Bestimmung eines Signalpegels bestimmte Ausgangssignal übertragen werden kann, beispielsweise an die in Fig. 1 dargestellte Steuer- und Auswerteeinrichtung 9.

In Fig. 4 ist schematisch ein Schaltdiagramm einer ersten Einrichtung 7 zur Sendeaktivitätsdetektion in einer weiteren Ausführungsform dargestellt. Die in Fig. 4 dargestellte erste Einrichtung 7 zur Sendeaktivitätsdetektion ist hierbei im Wesentlichen wie die in Fig. 3 dargestellte erste Einrichtung 7 zur Sendeaktivitätsdetektion ausgebildet. Im Unterschied zu der in Fig. 3 dargestellten Ausführungsform ist die erste Einrichtung 7 signaltechnisch unmittelbar über einen weiteren Verbindungssignalzweig 17 galvanisch mit der Dämpfungseinrichtung 5 verbunden. Das Schutzsignal SS kann hierbei über diesen weiteren Verbindungssignalzweig 17 übertragen werden.

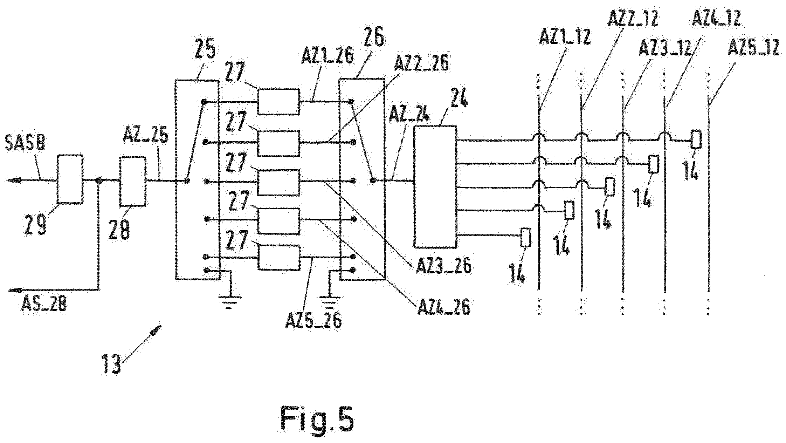

In Fig. 5 ist ein schematisches Schaltdiagramm einer weiteren Einrichtung 13 zur Sendeaktivitätsdetektion dargestellt. Die weitere Einrichtung 13 zur Sendeaktivitätsdetektion umfasst eine Einrichtung 24 zur Signalbündelung. Mittels dieser Einrichtung 24 zur Signalbündelung können die mittels der Signalkopplungseinrichtungen 14, die ebenfalls als Leistungskoppler ausgebildet sein können, aus den Ausgangssignalzweigen AZ1_12, ..., AZ5_12 der Signalverstärkungseinrichtung 12 (siehe Fig. 1) ausgekoppelten Signale gebündelt werden. Diese Einrichtung 24 zur Signalbündelung kann beispielsweise eine Splittereinrichtung und/oder eine Duplexereinrichtung umfassen. Auch kann die Einrichtung 24 zur Signalbündelung eine Daisy-Chain-Einrichtung umfassen oder als solche ausgebildet sein. Dies wird nachfolgend noch näher erläutert.

Weiter umfasst die weitere Einrichtung 13 zur Sendeaktivitätsdetektion eine erste Schalteinrichtung 25 sowie eine weitere Schalteinrichtung 26. Mittels der weiteren Schalteinrichtung 26 ist ein Ausgangssignalzweig AZ_24 der Einrichtung 24 zur Signalbündelung mit genau einem Ausgangssignalzweig AZ1_26, AZ2_26, AZ3_26, AZ4_26, AZ5_26 der weiteren Schalteinrichtung 26 verbindbar. Mittels der ersten Schalteinrichtung 25 ist jeder dieser Ausgangssignalzweige AZ1_26, ..., AZ5_26 mit einem Ausgangssignalzweig AZ_25 der ersten Schalteinrichtung 25 verbindbar. Weiter umfasst die weitere Einrichtung 13 zur Sendeaktivitätsdetektion Filtereinrichtungen 27, die insbesondere als Bandpassfiltereinrichtungen ausgebildet sein können. Wie vorhergehend bezüglich der ersten Einrichtung 7 zur Sendeaktivitätsdetektion erläutert, können die Bandpassfiltereinrichtungen derart ausgebildet sein, dass mittels der Bandpassfiltereinrichtungen Frequenzanteile aus dem auf den jeweiligen Ausgangssignalzweig AZ1_26, ..., AZ5_26 herausfilterbar sind, die Frequenzen in dem jeweiligen Sendeband aufweisen.

Weiter umfasst die weitere Einrichtung 13 eine Einrichtung 28 zur Bestimmung eines Signalpegels des auf dem Ausgangssignalzweig AZ_25 der ersten Schalteinrichtung 25 anliegenden Signals. Weiter umfasst die weitere Einrichtung 13 zur Sendeaktivitätsdetektion eine Komparatoreinrichtung 29, wobei mittels der Komparatoreinrichtung 29 ein Ausgangssignal der Einrichtung 28 zur Bestimmung eines Signalpegels, welches den Signalpegel repräsentiert und proportional zu diesem ist, mit einem vorbestimmten Signalpegel vergleichbar ist.

Ist der Signalpegel höher als der vorbestimmte Signalpegel, so kann mittels der Komparatoreinrichtung 29 ein sendebandspezifisches Sendeaktivitätssignal SASB erzeugt und übertragen werden, beispielsweise an die Steuer- und Auswerteeinrichtung 9. Die Steuer- und Auswerteeinrichtung 9 steuert hierbei Schaltzustände der Schalteinrichtungen 26, 25 der weiteren Einrichtung 13 zur Sendeaktivitätsdetektion synchron. Ist beispielsweise über die Schalteinrichtungen 25, 26 der erste Ausgangssignalzweig AZ1_26 der weiteren Schalteinrichtung 26 mit der Komparatoreinrichtung 29 signaltechnisch verbunden, so kann eine Sendeaktivität im ersten Sendeband detektiert werden, wenn das Ausgangssignal der Einrichtung 28 größer als der vorbestimmte Schwellwert ist.

Wird in diesem Schaltzustand also ein sendebandspezifisches Sendeaktivitätssignal SASB von der Komparatoreinrichtung 29 an die Steuer- und Auswerteeinrichtung 9 übertragen, so kann diese detektieren, dass in dem ersten Sendeband ein Sendesignal übertragen wird. In diesem Fall wird das erste Sendeband als aktives Sendeband identifiziert. Auch kann ein Ausgangssignal AS_28 der Einrichtung 28 zur Bestimmung eines Signalpegels an die Steuer- und Auswerteeinrichtung 9 übertragen werden. In Abhängigkeit dieses Ausgangssignals AS_28 kann die Steuer- und Auswerteeinrichtung 9 eine Sendeleistung des im ersten Sendeband übertragenen Sendesignals bestimmen. Ist diese zu hoch oder zu niedrig, kann beispielsweise ein Verstärkungsfaktor der Verstärkereinrichtung 12 (siehe Fig. 1) verändert, insbesondere verringert oder erhöht, werden.

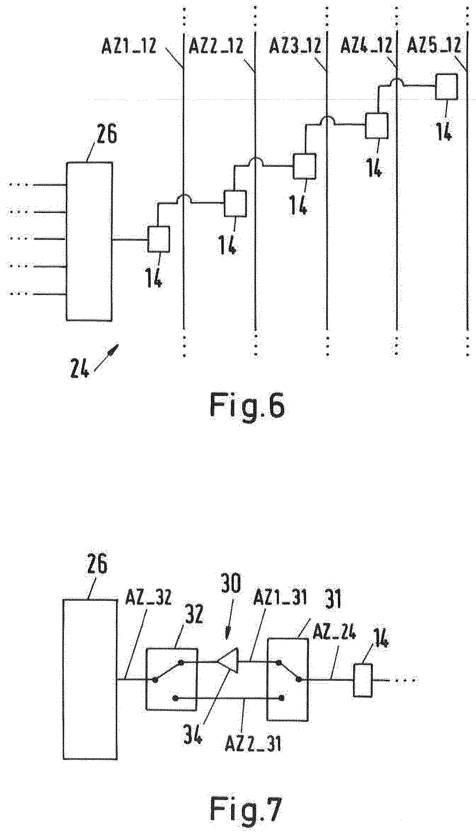

Fig. 6 zeigt ein schematisches Schaltdiagramm einer Einrichtung 24 zur Signalbündelung der weiteren Einrichtung 13 zur Sendeaktivitätsdetektion (siehe Fig. 5). Dargestellt sind Signalkopplungseinrichtungen, insbesondere als Leistungskoppler ausgebildete Signalkopplungseinrichtungen 14, die in einer sogenannten Daisy-Chain-Anordnung miteinander verschaltet sind. Durch diese Daisy-Chain-Anordnung wird eine Signalbündelung der aus den Ausgangssignalzweigen AZ1_12, ..., AZ5_12 ausgekoppelten Signale erreicht.

Fig. 7 zeigt eine aktivierbare und deaktivierbare Verstärkereinrichtungsschaltung 30, die insbesondere signaltechnisch zwischen der Einrichtung 24 zur Signalbündelung (siehe Fig. 5) und der weiteren Schalteinrichtungen 26 der weiteren Einrichtung 13 zur Sendeaktivitätsdetektion angeordnet sein kann. Diese Verstärkereinrichtungsschaltung 30 umfasst eine erste Schalteinrichtung 31 und eine weitere Schalteinrichtung 32. Mittels der ersten Schalteinrichtung 31 kann ein auf dem Ausgangssignalzweig AZ_24 der Einrichtung 24 zur Signalbündelung anliegendes Signal, also ein gebündeltes Signal, mit genau einem Ausgangssignalzweig AZ1_31, AZ2_31 der ersten Schalteinrichtung 31 verbunden werden. In dem ersten Ausgangssignalzweig AZ1_31 ist eine Verstärkereinrichtung 34 mit einem konstanten oder veränderbaren Verstärkungsfaktor angeordnet und verstärkt das auf diesem Ausgangssignalzweig AZ1_30 anliegende Signal. In dem weiteren Ausgangssignalzweig AZ2_31 ist keine Verstärkereinrichtung angeordnet. Mittels der weiteren Schalteinrichtung 32 kann genau einer der Ausgangssignalzweige AZ1_31, AZ2_31 der ersten Schalteinrichtung 31 mit einem Ausgangssignalzweig AZ_32 der weiteren Schalteinrichtung 32 verbunden werden. Somit kann das gebündelte Signal durch die Verstärkereinrichtungsschaltung 30 verstärkt oder nicht verstärkt werden.

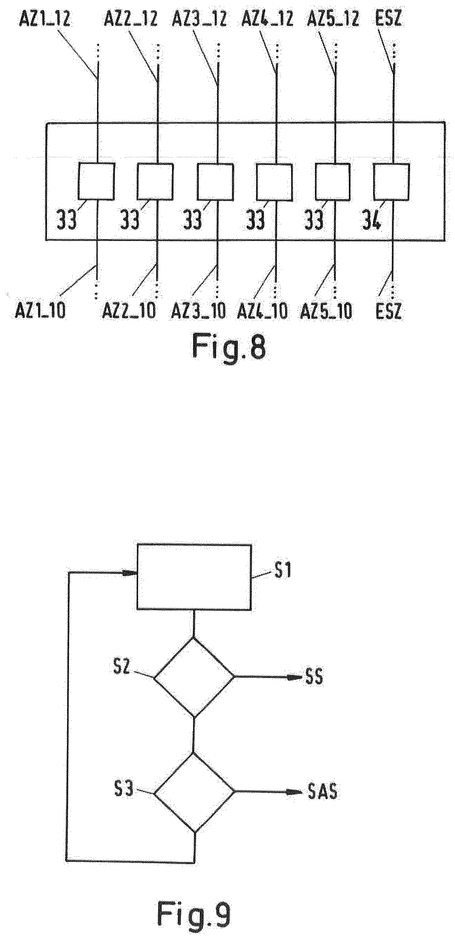

Fig. 8 zeigt ein schematisches Schaltdiagramm der in Fig. 1 dargestellten Verstärkereinrichtung 12. In Fig. 8 ist hierbei ein schematisches Schaltdiagramm einer sendebandspezifischen Verstärkereinrichtung 12 dargestellt. Insbesondere umfasst die sendebandspezifische Verstärkereinrichtung 12 Verstärkereinrichtungen 33 für jeden Signalzweig der fünf Ausgangssignalzweige AZ1_10, ..., AZ5_10 der ersten Schalteinrichtung 10 und eine Verstärkereinrichtung 34 für den Eingangssignalzweig ESZ. Da die Verstärkereinrichtung 12 durch die Steuer- und Auswerteeinrichtung 9 (siehe Fig. 1) steuerbar ist, können insbesondere signalzweigspezifische Verstärkungsfaktoren eingestellt werden.

In Fig. 9 ist ein schematisches Flussdiagramm eines erfindungsgemäßen Verfahrens zum Betrieb einer Signalkopplungsvorrichtung 1 (siehe Fig. 1) dargestellt. In einem ersten Schritt S1 wird mittels der ersten Einrichtung 7 zur Sendeaktivitätsdetektion eine Signaleigenschaft, insbesondere ein Signalpegel, eines aus dem Verbindungssignalzweig 6 (siehe Fig. 1) ausgekoppelten Signals bestimmt. In einem zweiten Schritt S2 wird die Signaleigenschaft mit einer schutzsignalspezifischen Signaleigenschaft verglichen. Ist diese Signaleigenschaft um mehr als ein vorbestimmtes Maß von einer vorbestimmten schutzsignalspezifischen Eigenschaft verschieden, so wird ein Schutzsignal SS erzeugt. Andernfalls wird die Signaleigenschaft oder eine weitere Signaleigenschaft, insbesondere wieder der Signalpegel, in einem dritten Schritt S3 mit einer startsignalspezifischen Signaleigenschaft verglichen. Ist diese Signaleigenschaft um mehr als ein vorbestimmtes Maß von einer vorbestimmten startsignalspezifischen Eigenschaft verschieden, so wird ein Startsignal SAS erzeugt. Andernfalls kann das Verfahren zum ersten Schritt S1 zurückkehren.

Im zweiten Schritt S2 kann das Schutzsignal SS insbesondere dann erzeugt werden, wenn ein Signalpegel größer als ein schutzsignalspezifischer Signalpegel ist. Im dritten Schritt S3 kann das Startsignal SAS insbesondere dann erzeugt werden, wenn der Signalpegel größer als ein startsignalspezifischer Signalpegel ist.

Wird ein Schutzsignal SS erzeugt, so kann eine Schutzfunktion durchgeführt werden, die die Bauteile der Signalkopplungsvorrichtung vor der Übertragung eines Sendesignals mit unerwünschten Signaleigenschaften schützt. Wird ein Startsignal SAS erzeugt, so kann die Identifikation eines aktiven Sendebands durch die weitere Einrichtung 13 zur Sendeaktivitätsdetektion gestartet werden.

### Bezugszeichenliste

- 1: Signalkopplungsvorrichtung
- 2: Endgerät
- 3: Sendesignal
- 4: endgeräteseitige Schnittstelle
- 5: Dämpfungseinrichtung
- 6: Verbindungssignalzweig
- 7: erste Einrichtung zur Sendeaktivitätsdetektion
- 8: Signalkopplungseinrichtung
- 9: Steuer- und Auswerteeinrichtung
- 10: erste Schalteinrichtung
- 11: Antenne
- 12: Verstärkereinrichtung
- 13: weitere Einrichtung zur Sendeaktivitätsdetektion
- 14: Signalkopplungseinrichtung
- 15: weitere Schalteinrichtung
- 16: Verstärkereinrichtung
- 17: weiterer Verbindungssignalzweig
- 18: Einrichtung zur Signaltrennung
- 19: Filtereinrichtung
- 20: Einrichtung zur Signalbündelung
- 21: Einrichtung zur Bestimmung eines Signalpegels
- 22: erste Komparatoreinrichtung
- 23: weitere Komparatoreinrichtung
- 24: Einrichtung zur Signalbündelung
- 25: erste Schalteinrichtung der weiteren Einrichtung zur Sendeaktivitätsdetektion
- 26: weitere Schalteinrichtung der weiteren Einrichtung zur Sendeaktivitätsdetektion
- 27: Filtereinrichtung
- 28: Einrichtung zur Bestimmung eines Signalpegels
- 29: Komparatoreinrichtung
- 30: Verstärkereinrichtungsschaltung
- 31: erste Schalteinrichtung
- 32: weitere Schalteinrichtung
- 33: Verstärkereinrichtung
- 34: Verstärkereinrichtung
- SS: Schutzsignal
- SAS: Startsignal
- EZ_10: Eingangssignalzweig der Schalteinrichtung
- ESZ: Empfangssignalzweig
- ASZ: Antennensignalzweig
- AZ1_12, ..., AZ5_12: Ausgangssignalzweige der Verstärkereinrichtung
- AZ1_10, ..., AZ5_10: Ausgangssignalzweige der ersten Schalteinrichtung 10
- AZ1_18, ..., AZ5_18: Ausgangssignalzweige der Einrichtung zur Signalbündelung
- AZ_20: Ausgangssignalzweig der Einrichtung zur Signalbündelung
- AS_21: Ausgangssignal der Einrichtung zur Bestimmung eines Signalpegels
- AZ_24: Ausgangssignalzweig der Einrichtung zur Signalbündelung
- AZ_25: Ausgangssignalzweig der ersten Schalteinrichtung
- AZ1_26, ..., AZ5_26: Ausgangssignalzweige der weiteren Schalteinrichtung
- SASB: sendebandspezifisches Sendeaktivitätssignal
- AS_28: Ausgangssignal der Einrichtung 28 zur Bestimmung eines Signalpegels
- AZ1_31, AZ2_31: Ausgangssignalzweige der ersten Schalteinrichtung 31
- AZ_32: Ausgangssignalzweig der weiteren Schalteinrichtung 32
- S1: erster Schritt
- S2: zweiter Schritt
- S3: dritter Schritt

## Patentansprüche

1. Signalkopplungsvorrichtung zur Übertragung von Sendesignalen zwischen einem Endgerät (2) und einer Antenne (11), wobei die Signalkopplungsvorrichtung (1) eine endgeräteseitige Schnittstelle (4) zur Herstellung einer signaltechnischen Verbindung zwischen der Signalkopplungsvorrichtung und dem Endgerät (2), mindestens eine Dämpfungseinrichtung (5) und mindestens einen Verbindungssignalzweig (6) zur Verbindung der endgeräteseitigen Schnittstelle (4) mit der Dämpfungseinrichtung (5) umfasst,
wobei die Signalkopplungsvorrichtung (1) mindestens eine erste Einrichtung (7) zur Sendeaktivitätsdetektion umfasst, wobei die erste Einrichtung (7) zur Sendeaktivitätsdetektion signaltechnisch mit dem Verbindungssignalzweig (6) gekoppelt ist, wobei mittels der ersten Einrichtung (7) zur Sendeaktivitätsdetektion ein Schutzsignal (SS) zur Steuerung der Dämpfungseinrichtung (5) erzeugbar ist, wenn mindestens eine Signaleigenschaft des auf dem Verbindungssignalzweig (6) anliegenden Signals mehr als ein vorbestimmtes Maß von einer vorbestimmten schutzsignalspezifischen Signaleigenschaft abweicht
**dadurch gekennzeichnet, dass**
das Schutzsignal (SS) erzeugbar ist, wenn eine Sendeleistung eines Sendesignals höher als eine vorbestimmte Schutzsignal-Leistung ist, wobei ein Dämpfungsfaktor der Dämpfungseinrichtung (5) erhöht wird, wenn ein Schutzsignal (SS) erzeugt wurde.

2. Signalkopplungsvorrichtung nach Anspruch 1, **dadurch gekennzeichnet, dass** die erste Einrichtung (7) zur Sendeaktivitätsdetektion unmittelbar mit der Dämpfungseinrichtung (5) verbunden ist.

3. Signalkopplungsvorrichtung nach einem der vorangegangenen Ansprüche, **dadurch gekennzeichnet, dass** die erste Einrichtung (7) zur Sendeaktivitätsdetektion eine Einrichtung zur sendebandunspezifische Sendeaktivitätsdetektion ist.

4. Signalkopplungsvorrichtung nach einem der vorangegangenen Ansprüche, **dadurch gekennzeichnet, dass** mittels der ersten Einrichtung (7) zur Sendeaktivitätsdetektion ein gebündeltes Signal erzeugbar ist, wobei das gebündelte Signal die in mindestens zwei Sendebändern übertragbaren Anteile des aus dem Verbindungssignalzweig (6) ausgekoppelten Signals bündelt, wobei das Schutzsignal (SS) in Abhängigkeit mindestens einer Signaleigenschaft des gebündelten Signals erzeugbar ist.

5. Signalkopplungsvorrichtung nach einem der vorangegangenen Ansprüche, **dadurch gekennzeichnet, dass** die erste Einrichtung (7) zur Sendeaktivitätsdetektion mindestens ein Mittel zur Signaltrennung und mindestens ein Mittel zur Signalbündelung umfasst.

6. Signalkopplungsvorrichtung nach einem der vorangegangenen Ansprüche, **dadurch gekennzeichnet, dass** die erste Einrichtung (7) zur Sendeaktivitätsdetektion mindestens ein Mittel zur Signalfilterung umfasst.

7. Signalkopplungsvorrichtung nach einem der vorangegangenen Ansprüche, **dadurch gekennzeichnet, dass** die erste Einrichtung (7) zur Sendeaktivitätsdetektion mindestens eine Einrichtung (21) zur Bestimmung eines Signalpegels und/oder mindestens eine Komparatoreinrichtung (22) umfasst.

8. Signalkopplungsvorrichtung nach einem der vorangegangenen Ansprüche, **dadurch gekennzeichnet, dass** die Signalkopplungsvorrichtung (1) eine weitere Einrichtung (13) zur Sendeaktivitätsdetektion umfasst.

9. Signalkopplungsvorrichtung nach Anspruch 8, **dadurch gekennzeichnet, dass** die Signalkopplungsvorrichtung (1) eine Signalverstärkungseinrichtung (12) umfasst, wobei mittels der weiteren Einrichtung (13)
zur Sendeaktivitätsdetektion ein aktives Sendeband in Abhängigkeit der durch die Signalverstärkungseinrichtung (17) verstärkten Sendesignale detektierbar ist, wobei in einem aktiven Sendeband ein Sendesignal übertragen wird.

10. Signalkopplungsvorrichtung nach Anspruch 8 oder 9, **dadurch gekennzeichnet, dass** die weitere Einrichtung (13) zur Sendeaktivitätsdetektion mindestens eine erste Schalteinrichtung (25) und für jedes Sendeband einen bandspezifischen Eingangssignalzweig umfasst, wobei durch die erste Schalteinrichtung (25) ein ausgewählter bandspezifischer Eingangssignalzweig mit einem Ausgangssignalzweig der ersten Schalteinrichtung (25) verbindbar ist, wobei eine Signaleigenschaft des in einem Sendeband übertragenen Sendesignals in Abhängigkeit einer Signaleigenschaft des auf dem Ausgangssignalzweigs (AZ_25) anliegenden Signals bestimmbar ist, wenn der entsprechende bandspezifische Eingangssignalzweig mit dem Ausgangssignalzweig (AZ_25) der ersten Schalteinrichtung (25) verbunden ist.

11. Signalkopplungsvorrichtung nach einem der Ansprüche 8 bis 10, **dadurch gekennzeichnet, dass** die weitere Einrichtung (13) zur Sendeaktivitätsdetektion mindestens eine Einrichtung (24) zur Signalbündelung und mindestens eine Einrichtung zur Signaltrennung des gebündelten Signals umfasst.

12. Signalkopplungsvorrichtung nach Anspruch 11, **dadurch gekennzeichnet, dass** die weitere Einrichtung (13) zur Sendeaktivitätsdetektion eine weitere Schalteinrichtung (26) umfasst, wobei durch die weitere Schalteinrichtung (26) ein Signalzweig (AZ_24) zur Übertragung des gebündelten Signals mit jedem bandspezifischen Eingangssignalzweig der ersten Schalteinrichtung (25) verbindbar ist.

13. Verfahren zum Betrieb einer Signalkopplungsvorrichtung (1) zur Übertragung von Sendesignalen zwischen einem Endgerät (2) und einer Antenne (11) gemäß einem der Ansprüche 1 bis 12, wobei mittels der ersten Einrichtung (7) zur Sendeaktivitätsdetektion ein Schutzsignal (SS) erzeugt wird, wenn mindestens eine Signaleigenschaft des auf dem Verbindungssignalzweig (6) anliegenden Signals mehr als ein vorbestimmtes Maß von einer vorbestimmten schutzsignalspezifischen Signaleigenschaft abweicht, wobei das Schutzsignal (SS) erzeugt wird, wenn eine Sendeleistung eines Sendesignals höher als eine vorbestimmte Schutzsignal-Leistung ist, wobei ein Dämpfungsfaktor der Dämpfungseinrichtung (5) erhöht wird, wenn ein Schutzsignal (SS) erzeugt wurde.

14. Verfahren nach Anspruch 13, **dadurch gekennzeichnet, dass** eine Schutzfunktion durchgeführt wird, wenn ein Schutzsignal (SS) erzeugt wurde.

15. Verfahren nach einem der Ansprüche 13 bis 14, **dadurch gekennzeichnet, dass** eine Sendeaktivitätsdetektion mittels einer weiteren Einrichtung (13) zur Sendeaktivitätsdetektion gestartet wird, wenn eine Sendeaktivität durch die erste Einrichtung (7) zur Sendeaktivitätsdetektion detektiert wurde.

## Claims

1. Signal coupling device for transmitting transmission signals between a terminal (2) and an antenna (11), wherein the signal coupling device (1) comprises a terminal-sided interface (4) for producing a technical signal connection between the signal coupling device and the terminal (2), at least one attenuation device (5), and at least one connecting signal branch (6) for connecting the terminal-sided interface (4) to the attenuation device (5), wherein the signal coupling device (1) comprises at least one first apparatus (7) for transmission activity detection, wherein the first apparatus (7) for transmission activity detection is signal-coupled to the connecting signal branch (6), wherein, by means of the first apparatus (7) for transmission activity detection, a protection signal (SS) can be generated for controlling the attenuation device (5) when at least one signal characteristic of the signal imposed on the connecting signal branch (6) deviates by more than a predetermined amount from a predetermined protection signal-specific signal characteristic,
**characterised in that**
the protection signal (SS) can be generated if a transmission power of a transmission signal is higher than a predetermined protection signal power, wherein an attenuating factor of the attenuation device (5) is increased if a protection signal (SS) has been generated.

2. Signal coupling device according to claim 1, **characterised in that** the first apparatus (7) for the transmission activity detection is connected directly to the attenuation device (5).

3. Signal coupling device according to any one of the preceding claims, **characterised in that** the first apparatus (7) for the transmission activity detection is a device for transmission activity detection not specified to a particular transmission band.

4. Signal coupling device according to any one of the preceding claims, **characterised in that**, by means of the first apparatus (7) for the transmission activity detection, a bundled signal can be generated, wherein the bundled signal bundles those portions of the signal which are decoupled from the connection signal branch and are transmittable in at least two transmission bands, wherein the protection signal (SS) can be generated in dependence on at least one signal characteristic of the bundled signal.

5. Signal coupling device according to any one of the preceding claims, **characterised in that** the first apparatus (7) for the transmission activity detection comprises at least one means for signal separation and at least one means for signal bundling.

6. Signal coupling device according to any one of the preceding claims, **characterised in that** the first apparatus (7) for the transmission activity detection comprises at least one means for signal filtering.

7. Signal coupling device according to any one of the preceding claims, **characterised in that** the first apparatus (7) for the transmission activity detection comprises at least one device (21) for determining a signal level and/or at least one comparator device (22).

8. Signal coupling device according to any one of the preceding claims, **characterised in that** the signal coupling device (1) comprises a further apparatus (13) for transmission activity detection.

9. Signal coupling device according to claim 8, **characterised in that** the signal coupling device (1) comprises a signal amplification device (12), wherein, by means of the further apparatus (13) for transmission activity detection, an active transmission band can be detected in dependence on the transmission signal amplified by the signal amplification device (12), wherein a transmission signal is transmitted in an active transmission band.

10. Signal coupling device according to claim 8 or 9, **characterised in that** the further apparatus (13) for transmission activity detection comprises at least one first switching device (25) and for each transmission band a band-specific input signal branch, wherein, by means of the first switching device (25), a selected band-specific input signal branch can be connected to an output signal branch of the first switching device (25), wherein a signal characteristic of the transmission signal transmitted in a transmission band can be determined in dependence on a signal characteristic of the signal imposed on the output signal branch (AZ_25) when the corresponding band-specific input signal branch is connected to the output signal branch (AZ_25) of the first switching device (25).

11. Signal coupling device according to any one of claims 8 to 10, **characterised in that** the further apparatus (13) for the transmission activity detection comprises at least one device (24) for the signal bundling and at least one device for the signal separation of the bundled signal.

12. Signal coupling device according to claim 11, **characterised in that** the further apparatus (13) for the transmission activity detection comprises a further switching device (26), wherein, by means of the further switching device (26), a signal branch (AZ_24) for the transmitting of the bundled signal can be connected to each band-specific input signal branch of the first switching device (25).

13. Method for the operation of a signal coupling device (1) for transmitting transmission signals between a terminal (2) and an antenna (11) according to any one of claims 1 to 12, wherein, by means of the first apparatus (7) for the transmission activity detection, a protection signal (SS) is generated if at least one signal characteristic of the signal imposed on the connection signal branch (6) deviates by more than a predetermined amount from a predetermined protection signal-specific signal characteristic, wherein the protection signal (SS) is generated if a transmission power of a transmission signal is higher than a predetermined protection signal power, wherein an attenuating factor of the attenuation device (5) is increased if a protection signal (SS) has been generated.

14. Method according to claim 13, **characterised in that** a protection function is carried out if a protection signal (SS) is generated.

15. Method according to any one of claims 13 to 14, **characterised in that** a transmission activity detection is started by means of a further apparatus (13) for transmission activity detection if a transmission activity has been detected by the first device (7) for the transmission activity detection.

## Revendications

1. Dispositif de couplage de signaux pour la transmission de signaux d'émission entre un terminal (2) et une antenne (11), dans lequel le dispositif de couplage de signaux (1) comprend une interface (4) côté terminal pour établir une liaison par une technique de signalisation entre le dispositif de couplage de signaux et le terminal (2), au moins un système d'atténuation (5) et au moins une branche de signaux de liaison (6) pour relier l'interface (4) côté terminal au système d'atténuation (5),
dans lequel le dispositif de couplage de signaux (1) comprend au moins un premier système (7) de détection d'activité d'émission, dans lequel le premier système (7) de détection d'activité d'émission est couplé par une technique de signalisation à la branche de signaux de liaison (6), dans lequel un signal de protection (SS) pour la commande du système d'atténuation (5) peut être généré au moyen du premier système (7) de détection d'activité d'émission quand au moins une propriété de signal du signal appliqué sur la branche de signaux de liaison (6) s'écarte d'une valeur supérieure à une mesure prédéfinie d'une propriété de signal prédéfinie spécifique au signal de protection,
**caractérisé en ce que**
le signal de protection (SS) peut être généré quand une puissance d'émission d'un signal d'émission est supérieure à une puissance de signal de protection prédéfinie, dans lequel un facteur d'atténuation du système d'atténuation (5) est augmenté quand un signal de protection (SS) a été généré.

2. Dispositif de couplage de signaux selon la revendication 1, **caractérisé en ce que** le premier système (7) de détection d'activité d'émission est relié directement au système d'atténuation (5).

3. Dispositif de couplage de signaux selon l'une quelconque des revendications précédentes, **caractérisé en ce que** le premier système (7) de détection d'activité d'émission est un système de détection d'activité d'émission non spécifique à la bande d'émission.

4. Dispositif de couplage de signaux selon l'une quelconque des revendications précédentes, **caractérisé en ce qu'**un signal regroupé peut être généré au moyen du premier système (7) de détection d'activité d'émission, dans lequel le signal regroupé regroupe les parties, pouvant être transmises dans au moins deux bandes d'émission, du signal découplé de la branche de signaux de liaison (6), dans lequel le signal de protection (SS) peut être généré en fonction d'au moins une propriété de signal du signal regroupé.

5. Dispositif de couplage de signaux selon l'une quelconque des revendications précédentes, **caractérisé en ce que** le premier système (7) de détection d'activité d'émission comprend au moins un moyen de séparation de signaux et au moins un moyen de regroupement de signaux.

6. Dispositif de couplage de signaux selon l'une quelconque des revendications précédentes, **caractérisé en ce que** le premier système (7) de détection d'activité d'émission comprend au moins un moyen de filtrage de signaux.

7. Dispositif de couplage de signaux selon l'une quelconque des revendications précédentes, **caractérisé en ce que** le premier système (7) de détection d'activité d'émission comprend au moins un système (21) de détermination d'un niveau de signaux et/ou au moins un système comparateur (22).

8. Dispositif de couplage de signaux selon l'une quelconque des revendications précédentes, **caractérisé en ce que** le dispositif de couplage de signaux (1) comprend un autre système (13) de détection d'activité d'émission.

9. Dispositif de couplage de signaux selon la revendication 8, **caractérisé en ce que** le dispositif de couplage de signaux (1) comprend un système d'amplification de signaux (12), dans lequel une bande d'émission active peut être détectée en fonction des signaux d'émission amplifiés par le système d'amplification de signaux (17) au moyen de l'autre système (13) de détection d'activité d'émission, dans lequel un signal d'émission est transmis dans une bande d'émission active.

10. Dispositif de couplage de signaux selon la revendication 8 ou 9, **caractérisé en ce que** l'autre système (13) de détection d'activité d'émission comprend au moins un premier système de commutation (25) et, pour chaque bande d'émission, une branche de signaux d'entrée spécifique à la bande, dans lequel une branche de signaux d'entrée spécifique à la bande choisie peut être reliée à une branche de signaux de sortie du premier système de commutation (25) par le premier système de commutation (25), dans lequel une propriété de signal du signal d'émission transmis dans une bande d'émission peut être définie en fonction d'une propriété de signal du signal appliqué sur la branche de signaux de sortie (AZ_25) quand la branche de signaux d'entrée spécifique à la bande correspondante est reliée à la branche de signaux de sortie (AZ_25) du premier dispositif de commutation (25).

11. Dispositif de couplage de signaux selon l'une quelconque des revendications 8 à 10, **caractérisé en ce que** l'autre système (13) de détection d'activité d'émission comprend au moins un système (24) de regroupement de signaux et au moins un système de séparation de signaux du signal regroupé.

12. Dispositif de couplage de signaux selon la revendication 11, **caractérisé en ce que** l'autre système (13) de détection d'activité d'émission comprend un autre système de commutation (26), dans lequel une branche de signaux (AZ_24) de transmission du signal regroupé peut être reliée à chaque branche de signaux d'entrée spécifique à la bande du premier système de commutation (25) par l'autre système de commutation (26).

13. Procédé pour faire fonctionner un dispositif de couplage de signaux (1) pour la transmission de signaux d'émission entre un terminal (2) et une antenne (11) selon l'une quelconque des revendications 1 à 12, dans lequel un signal de protection (SS) est généré au moyen du premier système (7) de détection d'activité d'émission quand au moins une propriété de signaux du signal appliqué sur la branche de signaux de liaison (6) s'écarte d'une valeur supérieure à une mesure prédéfinie d'une propriété de signal prédéfinie spécifique au signal de protection, dans lequel le signal de protection (SS) est généré quand une puissance d'émission d'un signal d'émission est supérieure à une puissance de signal de protection prédéfinie, dans lequel un facteur d'atténuation du système d'atténuation (5) est augmenté quand un signal de protection (SS) a été généré.

14. Procédé selon la revendication 13, **caractérisé en ce qu'**une fonction de protection est mise en œuvre quand un signal de protection (SS) a été généré.

15. Procédé selon l'une quelconque des revendications 13 à 14, **caractérisé en ce qu'**une détection d'activité d'émission est démarrée au moyen d'un autre système (13) de détection d'activité d'émission quand une activité d'émission a été détectée par le premier système (7) de détection d'activité d'émission.
